(19) Europäisches Patentamt
European Patent Office
Office européen des brevets

(11) EP 4 394 866 A1

(12) EUROPEAN PATENT APPLICATION
published in accordance with Art. 153(4) EPC

(43) Date of publication:
03.07.2024 Bulletin 2024/27

(51) International Patent Classification (IPC):
H01L 25/075 (2006.01)    H01L 27/12 (2006.01)
H01L 33/62 (2010.01)     H01L 33/36 (2010.01)
H01L 33/40 (2010.01)     H01L 23/00 (2006.01)

(21) Application number: 22904729.5

(22) Date of filing: 12.12.2022

(52) Cooperative Patent Classification (CPC):
H01L 33/62; H01L 25/0753; H01L 25/167;
H01L 33/0095; H01L 33/486; H01L 2933/0066

(86) International application number:
PCT/KR2022/020156

(87) International publication number:
WO 2023/106900 (15.06.2023 Gazette 2023/24)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 10.12.2021 JP 2021200625

(71) Applicant: Samsung Electronics Co., Ltd.
Suwon-si, Gyeonggi-do 16677 (KR)

(72) Inventors:
• YANAGISAWA, Satoshi
  Suwon-si, Gyeonggi-do 16677 (KR)
• TAKAGI, Takashi
  Suwon-si, Gyeonggi-do 16677 (KR)
• FUJIWARA, Tsubasa
  Suwon-si, Gyeonggi-do 16677 (KR)
• WADA, Masaru
  Suwon-si, Gyeonggi-do 16677 (KR)

(74) Representative: Gulde & Partner
Patent- und Rechtsanwaltskanzlei mbB
Wallstraße 58/59
10179 Berlin (DE)

(54) **DISPLAY DEVICE AND METHOD FOR MANUFACTURING DISPLAY DEVICE**

(57) A display apparatus includes a micro-light-emitting device comprising at least two device-side electrodes, a driving substrate comprising at least two driving substrate-side electrodes, and at least two metal layers, each metal layer being at least two metal layers, each metal layer being interposed between a corresponding device-side electrode, among the at least two device-side electrodes, and a corresponding driving substrate-side electrode, among the at least two driving substrate-side electrodes, and connecting the corresponding device-side electrode, among the at least two device-side electrodes, to the corresponding driving substrate-side electrode, among the at least two driving substrate-side electrodes. A distance between adjacent driving substrate-side electrodes, among the at least two driving substrate-side electrodes, is greater than a distance between adjacent device-side electrodes, among the at least two device-side electrodes, and each metal layer of the at least two metal layers is a metal formed by undergoing heating without pressure applied thereto and then curing during a process of connecting the at least two device-side electrodes to the at least two driving substrate-side electrodes.

FIG. 1

**Description**

TECHNICAL FIELD

The disclosure relates to a display apparatus and a method of manufacturing the display apparatus.

BACKGROUND ART

Display apparatuses using micro-light-emitting diodes (micro-LEDs) are considered to be the next-generation of display apparatuses because they are capable of displaying a high-brightness and high-definition image with a high response speed and low power consumption.

For manufacturing a display apparatus using micro-LEDs, it is necessary to connect a micro-LED chip of 100 µm or less to a driving substrate.

DESCRIPTION OF EMBODIMENTS

TECHNICAL PROBLEM

In order to connect a micro-light-emitting diode (micro-LED) to a driving substrate, the micro-LED needs to be arranged at a certain position on the driving substrate. Because the micro-LED is minute, even when slight misalignment occurs, image quality of a display apparatus may deteriorate.

In the related art, a micro-LED is arranged to face a driving substrate and then simultaneously heated and applied with pressure, and thus, even when the position of the micro-LED is misaligned with the driving substrate, the pressure heating process causes the micro-LED to be connected to the driving substrate. However, the pressure-heating process does not reduce misalignment of the micro-LED, and furthermore when pressure is applied to the micro-LED it is possible to damage the light-emitting device.

An embodiment of the disclosure may provide a display apparatus with reduced misalignment of a light-emitting device on a driving substrate.

In addition, an embodiment of the disclosure may provide a method of manufacturing a display apparatus with reduced misalignment of a light-emitting device on a driving substrate.

SOLUTION TO PROBLEM

In accordance with an aspect of the disclosure, a display apparatus includes: a driving substrate comprising at least two driving substrate-side electrodes; and at least two metal layers, each metal layer being at least two metal layers, each metal layer being interposed between a corresponding device-side electrode, among the at least two device-side electrodes and a corresponding driving substrate-side electrode, among the at least two driving substrate-side electrodes, and connecting the corresponding device-side electrode, among the at least two device-side electrodes, to the corresponding driving substrate-side electrode, among the at least two driving substrate-side electrodes, where a distance between adjacent driving substrate-side electrodes, among the at least two driving substrate-side electrodes, is greater than a distance between adjacent device-side electrodes, among the at least two device-side electrodes, and each metal layer of the at least two metal layers is a metal formed by undergoing heating without pressure applied thereto and then curing during a process of connecting the at least two device-side electrodes to the at least two driving substrate-side electrodes.

The dimensions of a device-side electrode, among the adjacent device-side electrodes, and a driving substrate-side electrode, among the adjacent driving substrate-side electrodes, may be determined according to Equations (1), (2), (3), (4), and (5):

$$(1)\ d < x - (a + c - z)/2;$$

$$(2)\ y/2 > d;$$

$$(3)\ z < a + c;$$

$$(4)\ x < 2a+c-z;$$

and

$$(5)\ y < a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, z denotes a distance between the adjacent driving substrate-side electrodes, and d denotes a difference between a center between the adjacent device-side electrodes and a center between the adjacent driving substrate-side electrodes.

The dimensions of a device-side electrode, among the at least two device-side electrodes, and a driving substrate-side electrode, among the at least two driving substrate-side electrodes, may be determined according to Equations (1), (2), (3), and (4):

$$(1)\ \sqrt{(x^2+y^2)} < a+c;$$

$$(2)\ z < a+c;$$

$$(3)\ x < 2a+c-z;$$

and

$$(4)\ y < a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, and z denotes a distance between the adjacent driving substrate-side electrodes.

A volume V of a metal layer of the at least two metal layers may be determined according to Equation (5):

$$(5)\ 0.059 \times a \times b^2 < V < 0.393 \times a \times b^2,$$

where b denotes a length of the device-side electrode in the Y direction.

The each of the at least two metal layers may include a Sn-Ag-Cu (SAC) alloy solder material.

Each of the at least two device-side electrodes may each comprise an electrode metal layer and a barrier metal layer, which are sequentially arranged from a side adjacent to the micro-light-emitting device.

The barrier metal layer may include Ni.

A surface of each of the at least two device-side electrodes and a surface of each of the at least two driving substrate-side electrodes comprise an element from Group 10 or Group 11 of the periodic table of elements.

In accordance with an aspect of the disclosure, a method of manufacturing a display apparatus in which a micro-light-emitting device and a driving substrate are connected to each other, includes: depositing a metal layer on at least one of at least two device-side electrodes of the micro-light-emitting device and at least two driving substrate-side electrodes of the driving substrate; transferring the micro-light-emitting device onto the driving substrate such that the at least two driving substrate-side electrodes and the at least two device-side electrodes correspond to each other, respectively; and heating, without applying pressure, the driving substrate to which the micro-light-emitting device is transferred.

A distance between adjacent driving substrate-side electrodes, among the at least two driving substrate-side electrodes may be greater than a distance between adjacent device-side electrodes, among the at least two device-side electrodes.

The dimensions of a device-side electrode, among the adjacent device-side electrodes, and a driving substrate-side electrode, among the adjacent driving substrate-side electrodes, may be determined according to Equations (1), (2), (3), (4), and (5):

$$(1)\ d < x - (a+c-z)/2;$$

$$(2)\ y/2 > d;$$

$$(3)\ z < a+c;$$

$$(4)\ x < 2a+c-z;$$

and

$$(5)\ y < a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, z denotes a distance between the adjacent driving substrate-side electrodes, and d denotes a difference between a center between the adjacent device-side electrodes and a center between the adjacent driving substrate-side electrodes.

The dimensions of a device-side electrode, among the at least two device-side electrodes, and a driving substrate-side electrode, among the at least two driving substrate-side electrodes, may be determined according to Equations (1), (2), (3), and (4):

$$(1)\ \sqrt{(x^2 + y^2)} < a+c;$$

$$(2)\ z < a+c;$$

$$(3)\ x < 2a+c-z;$$

and

$$(4)\ y < a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, and z denotes a distance between the adjacent driving substrate-side electrodes.

A volume V of the metal layer may be determined according to Equation (6):

$$(6)\ 0.059 \times a \times b^2 < V < 0.393 \times a \times b^2,$$

where b denotes a length of the device-side electrode in the Y direction.

In accordance with an aspect of the disclosure, a display apparatus includes: a micro-light-emitting device; at least two device-side electrodes provided on the micro-light-emitting device; a driving substrate; at least two driving substrate-side electrodes provided on the driving substrate; at least two metal layers, each metal layer being interposed between a corresponding device-side electrode, among the at least two device-side electrodes and a corresponding driving substrate-side electrode, among the at least two driving substrate-side electrodes, and connecting the corresponding device-side electrode, among the at least two device-side electrodes, to the corresponding driving substrate-side electrode, among the at least two driving substrate-side electrodes, respectively; and a pore in an area between adjacent device-side electrodes, among the at least two device-side electrodes, and between adjacent driving substrate-side electrodes, among the at least two driving substrate-side electrodes, that are connected to the adjacent device-side electrodes, respectively, where the pore has a polygonal cross-sectional shape that is line-symmetric with respect to a center line passing through a center between the adjacent device-side electrodes and a center between the adjacent driving substrate-side electrodes.

The pore may have a trapezoidal cross-sectional shape including an upper base between the adjacent device-side electrodes of the micro-light-emitting device, a lower base between the adjacent driving substrate-side electrodes of the driving substrate, and a lateral portion between the upper base and the lower base.

A dimension of a device-side electrode, among the adjacent device-side electrodes, and a dimension of a driving substrate-side electrode, among the adjacent driving substrate-side electrodes, may be determined according to Equations (1), (2), (3), (4), and (5):

$$(1)\ d < x - (a+c-z)/2;$$

$$(2)\ y/2 > d;$$

$$(3)\ z < a+c;$$

$$(4)\ x < 2a+c-z;$$

and

$$(5)\ y < a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, z denotes a distance between the adjacent driving substrate-side electrodes, and d denotes a difference between a center between the adjacent device-side electrodes and a center between the adjacent driving substrate-side electrodes.

A dimension of a device-side electrode, among the at least two device-side electrodes, and a dimension of a driving substrate-side electrode, among the at least two driving substrate-side electrodes, may be determined according to Equations (1), (2), (3), and (4):

$$(1)\ \sqrt{(x^2+y^2)} < a+c;$$

$$(2)\ z < a+c;$$

$$(3)\ x<2a+c-z;$$

and

$$(4)\ y<a+c,$$

where a direction in which the adjacent device-side electrodes and the adjacent driving substrate-side electrodes are arranged is a first direction (an X direction), a direction orthogonal to the first direction X is a second direction (a Y direction), and where a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, and z denotes a distance between the adjacent driving substrate-side electrodes.

A volume V of the metal layer may be determined according to Equation (6):

$$(6)\ 0.059 \times a \times b^2 < V < 0.393 \times a \times b^2,$$

where b denotes a length of the device-side electrode in the Y direction.

ADVANTAGEOUS EFFECTS OF DISCLOSURE

According to one or more embodiments of the disclosure, a light-emitting device is connected to a driving substrate by using a pressureless heating process, and thus misalignment of the position of the light-emitting device on the driving substrate may be reduced.

According to one or more embodiments of the disclosure, by arranging driving substrate-side electrodes and device-side electrodes such that the distance between the driving substrate-side electrodes is greater than the distance between the device-side electrodes, misalignment in the direction of rotation of the light-emitting device on the driving substrate may be reduced.

According to one or more embodiments of the disclosure, the light-emitting device may be connected to the driving substrate in a pressureless manner, and thus it may be possible to prevent damage to the light-emitting device which may occur when pressure is applied thereto.

BRIEF DESCRIPTION OF THE DRAWINGS

The above and other aspects, features, and advantages of certain embodiments of the present disclosure will be more apparent from the following description taken in conjunction with the accompanying drawings, in which:

FIG. 1 is a schematic cross-sectional view of a display apparatus, according to an embodiment of the disclosure;
FIG. 2 is an enlarged cross-sectional view of a micro-light-emitting diode (micro-LED), according to an embodiment of the disclosure;
FIG. 3 is a plan view for describing the size of each device-side electrode, according to an embodiment of the disclosure;
FIG. 4 is a plan view for describing the size of each driving substrate-side electrode, according to an embodiment of the disclosure.;
FIG. 5 is a plan view illustrating a state in which a micro-LED is transferred to a preferred position on a driving substrate, according to an embodiment of the disclosure;
FIG, 6 is a plan view illustrating a state in which a micro-LED is misaligned and then transferred to a driving substrate, according to an embodiment of the disclosure;
FIG. 7 is a plan view for describing a linear shift amount, according to an embodiment of the disclosure;
FIG. 8 is a plan view for describing a rotation shift amount, according to an embodiment of the disclosure;
FIG. 9 is a plan view illustrating a state in which a device-side electrode and a driving substrate-side electrode are connected to each other, when viewed from a micro-LED, according to an embodiment of the disclosure;
FIG. 10 is a cross-sectional view illustrating a state in which a solder layer (a solder material) is deposited on a device-side electrode, according to an embodiment of the disclosure;
FIG. 11 is a cross-sectional view illustrating a state of a solder layer during pressureless heating (reflow), according to an embodiment of the disclosure;

FIG. 12 is an enlarged cross-sectional view illustrating a device-side electrode that is heated without applying pressure thereto (reflow), according to an embodiment of the disclosure;

FIG. 13 is a cross-sectional view for describing a positional relationship between a molten solder layer and a driving substrate-side electrode when a self-alignment effect occurs, according to an embodiment of the disclosure;

FIG. 14 is a cross-sectional view for describing the surface tension of a molten solder layer, according to an embodiment of the disclosure;

FIG. 15 is a cross-sectional view for describing a state in which a device-side electrode is connected to a driving substrate-side electrode, according to an embodiment of the disclosure;

FIG. 16 is a plan view for describing self-alignment for linear misalignment, according to an embodiment of the disclosure;

FIG. 17 is a plan view for describing self-alignment for linear misalignment, according to an embodiment of the disclosure;

FIG. 18 is a cross-sectional view for describing a positional relationship between a molten solder layer and a driving substrate-side electrode when there is a possibility that no self-alignment effect occurs, according to an embodiment of the disclosure;

FIG. 19 is a plan view for describing self-alignment for linear misalignment, according to an embodiment of the disclosure;

FIG. 20 is a plan view for describing linear misalignment, according to an embodiment of the disclosure;

FIGS. 21 to 24 are plan views for describing self-alignment for rotational misalignment, according to an embodiment of the disclosure;

FIGS. 25 to 27 are plan views for describing self-alignment for rotational misalignment, according to an embodiment of the disclosure;

FIG. 28 is a plan view for describing self-alignment for linear misalignment, according to an embodiment of the disclosure;

FIG. 29 is a plan view for describing self-alignment for linear misalignment, according to an embodiment of the disclosure;

FIG. 30 is a plan view for describing self-alignment for rotational misalignment, according to an embodiment of the disclosure;

FIG. 31 is a plan view for describing self-alignment for linear misalignment, according to an embodiment of the disclosure;

FIG. 32 is a plan view for describing self-alignment for linear misalignment, according to an embodiment of the disclosure;

FIG. 33 is a plan view for describing self-alignment for rotational misalignment, according to an embodiment of the disclosure;

FIGS. 34 to 44 are cross-sectional views for describing the method of manufacturing a display apparatus, according to an embodiment of the disclosure;

FIG. 45 is a plan view illustrating a state immediately after a micro-LED is transferred to a driving substrate, according to an embodiment of the disclosure;

FIG. 46 is a plan view illustrating a state in which a micro-LED is connected to a driving substrate, according to an embodiment of the disclosure;

FIG. 47 is a cross-sectional view illustrating a test substrate, according to an embodiment of the disclosure;

FIG. 48 is a plan view for describing measurement of a shift amount, according to an embodiment of the disclosure;

FIG. 49 is a scanning electron microscope (SEM) image showing a connection portion between a micro-LED and a driving substrate, which are undamaged (not defective) products, according to an embodiment of the disclosure; and

FIG. 50 is an SEM image showing a connection portion between a micro-LED and a driving substrate, which are defective products, according to a comparative example.

MODE OF DISCLOSURE

Throughout the disclosure, the expression "at least one of a, b or c" indicates only a, only b, only c, both a and b, both a and c, both b and c, or all of a, b, and c.

Hereinafter, embodiments of the disclosure are described in detail with reference to the accompanying drawings. However, the following descriptions are essentially provided only by way of examples and are not intended to limit the disclosure, and applications or uses thereof.

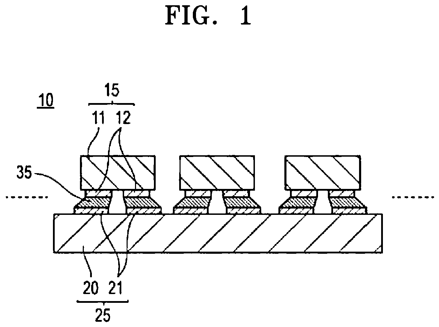

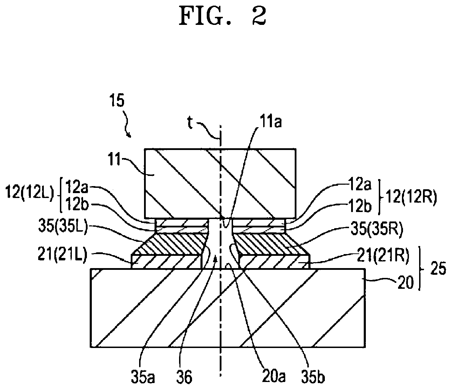

FIG. 1 is a schematic cross-sectional view of a display apparatus 10, according to an embodiment of the disclosure. FIG. 2 is an enlarged cross-sectional view of a micro-light-emitting diode (micro-LED) 15, according to an embodiment of the disclosure.

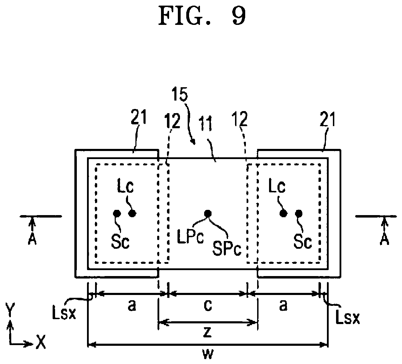

FIGS. 1 and 2 are cross-sectional views of the display apparatus 10, taken along the direction passing through device-side electrodes 12 and driving substrate-side electrodes 21. In other words, FIGS. 1 and 2 illustrate cross sections of the display apparatus 10, taken along line AA in FIG. 9 to be described below. The same applies to other cross-sectional views to be described below.

Referring to FIG. 1, the display apparatus 10 according to an embodiment of the disclosure may include a driving substrate 25 and a micro-LED 15, which is a micro-light-emitting device connected to a top surface of the driving substrate 25. According to an embodiment of the disclosure, three micro-LEDs 15 are illustrated in FIG. 1. For example, each micro-LED 15 may implement a color pixel such as a red (R), green (G), or blue (B) pixel. For example, the display apparatus 10 having a resolution of 4K may include about 8.3 million pixels, and thus may include about 24 million micro-LEDs 15, which is three times of 8.3 million.

The micro-LED 15 may include two electrodes (referred to as the device-side electrodes 12). The device-side electrodes 12 according to an embodiment of the disclosure may be provided on a semiconductor chip 11 included in the micro-LED 15, and spaced a certain interval from each other.

The driving substrate 25 may include two electrodes (referred to as the driving substrate-side electrodes 21) at positions corresponding to the device-side electrodes 12, respectively. The driving substrate-side electrode 21 according to an embodiment of the disclosure may include a wiring layer, a transistor (e.g., a thin-film transistor (TFT)), an insulating layer, and the like, on a base substrate 20 that includes, for example, a glass material, a resin material, and other materials.

For example, the device-side electrodes 12 may be an anode electrode and a cathode electrode, respectively. Accordingly, the micro-LED 15 may include two electrodes. The driving substrate-side electrodes 21 may include two electrodes respectively corresponding to two electrodes of the device-side electrodes 12. However, the disclosure is not limited thereto, and the number of device-side electrodes 12 may be three or more depending on the specification or function of the micro-LED 15. In this case, the number of driving substrate-side electrodes 21 may also increase to correspond to the number of electrodes of the micro-LED 15.

The device-side electrode 12 and the driving substrate-side electrode 21 may be connected to each other by a metal layer 35 between the device-side electrode 12 and the driving substrate-side electrode 21. In the metal layer 35 according to an embodiment of the disclosure, a solder material may be melted by applying heat thereto without applying pressure, and then cured.

Referring to FIG. 2, the device-side electrode 12 may include an electrode metal layer 12a and a barrier metal layer 12b. The electrode metal layer 12a and the barrier metal layer 12b according to an embodiment of the disclosure may include, for example, a Group 10 or 11 element. For example, the electrode metal layer 12a and the barrier metal layer 12b may include at least one metal selected from the group consisting of Au, Ag, Cu, Al, Pt, Ni, Cr, Ti, and ITO, or graphene. For example, the barrier metal layer 12b may include nickel (Ni). When the barrier metal layer 12b includes nickel (Ni), solder erosion due to the formation of a metal compound that may occur in a heating process may be suppressed, and thus a self-alignment effect to be described below may be secured. In addition, when a flux is used in a pressureless heating process, the bonding properties between the electrode and the solder, and thus a self-alignment effect may be secured.

The driving substrate-side electrode 21 according to an embodiment of the disclosure may include the same metal material as that of the device-side electrode 12. For example, surfaces of the device-side electrode 12 and the driving substrate-side electrode 21, which are in contact with the metal layer 35, may include a Group 10 or 11 element.

In consideration of the heat resistance of the driving substrate 25, the metal layer 35 may include, for example, a solder material having a liquefaction temperature of 280 °C or less. For example, the solder material may be an alloy including at least one element from Groups 10, 11, 12, 13, 14, and 15 of the periodic table of elements. For example, the solder material may include at least one alloy selected from the group consisting of Sn-Ag-Cu alloy (SAC), Sn-Bi alloy, Sn-Bi-Ag alloy, and Sn-Ag-Cu-Ni alloy.

For example, by heating the solder material without applying pressure, the solder material may be melted and then liquefied. The device-side electrode 12 and the driving substrate-side electrode 21 may be connected to each other by using the liquefied solder material. At this time, the surface tension of the liquefied solder material may cause a force that attracts the device-side electrode 12 and the driving substrate-side electrode 21. Accordingly, the micro-LED 15 may be self-aligned to a correct position on the driving substrate 25 within an allowable range.

Hereinafter, a state is described in which the micro-LED 15 is connected to the driving substrate 25. In the specification, the shape in which the micro-LED 15 is connected to the driving substrate 25 is referred to as a completed shape.

According to an embodiment of the disclosure, in the completed shape, a pore 36 may be at a portion in which the device-side electrode 12 and the driving substrate-side electrode 21 are connected to each other. The pore 36 may be between the device-side electrodes 12 adjacent to each other and between the driving substrate-side electrodes 21 adjacent to each other. For example, the pore 36 may be surrounded by a first device-side electrode 12R, a first metal layer 35R, a first driving substrate-side electrode 21R, a second device-side electrode 12L, a second metal layer 35L, and a second driving substrate-side electrode 21L.

For example, the pore 36 may have a polygonal cross-sectional shape. For example, the polygonal shape may be in a symmetrical structure with respect to a center line t passing through the center between the adjacent device-side electrodes 12 and the center between the adjacent driving substrate-side electrodes 21.

The pore 36 according to an embodiment of the disclosure may have a trapezoidal cross-sectional shape including an upper base 11a between the adjacent device-side electrodes 12, a lower base 20a between the adjacent driving substrate-side electrodes 21, and lateral portions 35a and 35b between the upper base 11a and the lower base 20a. Here, the lateral portions 35a and 35b may be side surfaces of the pore 36 of the metal layer 35.

In the completed shape according to an embodiment of the disclosure, the driving substrate-side electrode 21 may be formed to be larger than the device-side electrode 12.

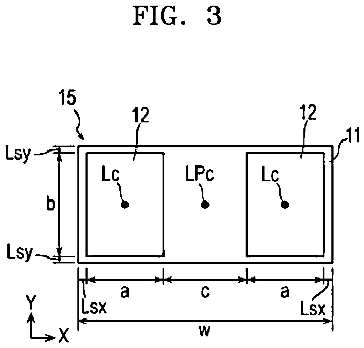

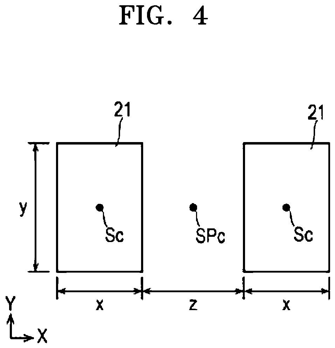

FIG. 3 is a plan view for describing the size of each device-side electrode 12 according to an embodiment of the disclosure. FIG. 4 is a plan view for describing the size of each driving substrate-side electrode 21 according to an embodiment of the disclosure.

Referring to FIGS. 3 and 4, a direction parallel to a surface on which two device-side electrodes 12 and two driving substrate-side electrodes 21 according to an embodiment of the disclosure are arranged is defined as a first direction (X direction), and a direction perpendicular to the first direction (X direction) and parallel to the surface on which the device-side electrodes 12 and the driving substrate-side electrodes 21 are arranged is defined as a second direction (Y direction).

As illustrated in FIG. 3, the dimensions of each device-side electrode 12 may include the length in the first direction (X direction) denoted by a, the length in the second direction (Y direction) denoted by b, and the inter-electrode distance (i.e., the distance between the device-side electrodes 12 adjacent to each other in the X direction) denoted by c. In addition, the position of an electrode in the chip of the micro-LED 15 may be expressed by using the distance between an end of the micro-LED 15 and an end of the device-side electrode 12. For example, the distance in the X direction between an end of the micro-LED 15 to an end of the device-side electrode 12 may be denoted by $L_{sx}$, and the distance in the Y direction therebetween may be denoted by $L_{sy}$.

As illustrated in FIG. 4, the dimensions of each driving substrate-side electrode 21 may include the length in the first direction (X direction) denoted by x, the length in the second direction (Y direction) denoted by y, and the inter-electrode distance (i.e., the distance between the driving substrate-side electrodes 21 adjacent to each other in the X direction) denoted by z.

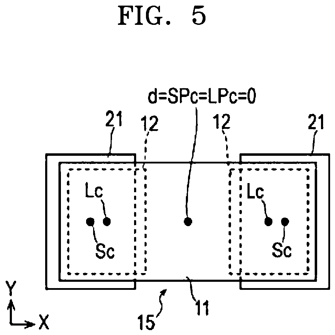

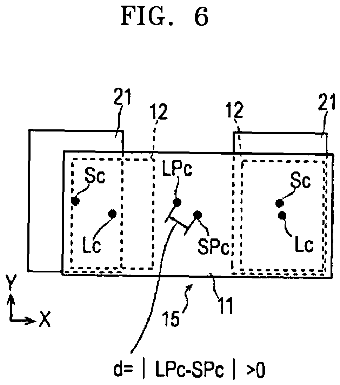

According to an embodiment of the disclosure, the difference between the center between the adjacent device-side electrodes and the center between the adjacent driving substrate-side electrodes may be denoted by d (see FIGS. 5 and 6). In a manufacturing process, d is a distance by which the micro-LED 15 moves from a position at which the micro-LED 15 is transferred through a transfer process, to a position determined in a design phase (hereinafter, referred to as a "correct position"). Hereinafter, d is referred to as a shift amount d. When a display apparatus is completed according to an embodiment of the disclosure, that is, even after completion of the pressureless heating process (after the display apparatus is manufactured), the difference between the center between adjacent device-side electrodes and the center between adjacent driving substrate-side electrodes does not exceed the shift amount d.

Here, the transfer process refers to a process of placing the micro-LED 15 on the driving substrate 25 in order to connect the micro-LED 15 to a top surface of the driving substrate 25, and the pressureless heating process refers to a process of soldering (connecting) the micro-LED 15 on the driving substrate 25 by applying heat without applying pressure.

FIG. 5 is a plan view illustrating a state in which the micro-LED 15 according to an embodiment of the disclosure is transferred to a preferred position on the driving substrate 25. FIG, 6 is a plan view illustrating a state in which the micro-LED 15 according to an embodiment of the disclosure is misaligned and then transferred to the driving substrate 25.

In the specification, the distance between a center $LP_c$ between device-side electrodes and a center $SP_c$ between driving substrate-side electrodes in the transfer process is defined as a transfer-process shift amount ($LP_c$-$SP_c$). In addition, the distance between the center $LP_c$ between the device-side electrodes and the center $SP_c$ between the driving substrate-side electrodes after the pressureless heating process is defined as a pressureless-heating-process shift amount ($LP_c$-$SP_c$). In the manufacturing process, the shift amount d is the difference between the transfer-process shift amount ($LP_c$-$SP_c$) and the pressureless-heating-process shift amount ($LP_c$-$SP_c$). That is, the shift amount d may be d = (transfer-process shift amount ($LP_c$-$SP_c$)) - (pressureless-heating-process shift amount ($LP_c$-$SP_c$)).

In the transfer process according to an embodiment of the disclosure, a preferred correct position is position in which the center $LP_c$ between the device-side electrode and the center $SP_c$ between the driving substrate-side electrode completely coincide with each other. Therefore, as illustrated in FIG. 5, in the preferred correct position, shift amount d = $LP_c$-$SP_c$ = 0.

In addition, when the micro-LED 15 is transferred to an incorrect position other than the correct position (for the correct position, d = 0) in the transfer process according to an embodiment of the disclosure, as illustrated in FIG. 6, the shift amount d may be d > 0, that is, d = | $LP_c$ - $SP_c$ | > 0.

When the micro-LED 15 according to an embodiment of the disclosure is transferred to an incorrect position, the micro-LED 15 may move to the correct position (d = 0) illustrated in FIG. 5 by a self-alignment effect, and then connected (soldered) to the driving substrate 25. At this time, the amount of movement by the self-alignment effect is equal to the shift amount d.

However, in the pressureless heating process according to an embodiment of the disclosure, the final connection position of the micro-LED 15 may be out of the preferred correct position (d = 0) despite the self-alignment effect. Therefore, in an actual manufacturing process, a tolerance may be set for the final position of the micro-LED 15. The tolerance for the final connection position of the micro-LED 15 may be arbitrarily set according to the size of the micro-LED 15 or a tolerance for the position of each micro-LED 15 in a finished product. For example, in case of a chip in which the length of the long side of the micro-LED 15 is 100 $\mu$m, the allowable range of the final connection position of the micro-LED 15 may be less than LPc - SPc = $\pm 1$ $\mu$m.

The shift amount d according to an embodiment of the disclosure may be obtained by measuring, for example, the distance between the center between the adjacent device-side electrodes 12 (the center LPc between device-side electrodes) and the center between the adjacent driving substrate-side electrodes 21 (the center SPc between driving substrate-side electrodes).

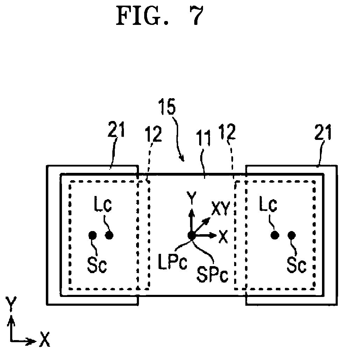

FIG. 7 is a plan view for describing a linear shift amount according to an embodiment of the disclosure.

Referring to FIG. 7, the direction of the linear shift amount d according to an embodiment of the disclosure is any one of the first direction (X direction), the second direction (Y direction), or an XY direction between the first direction (X direction) and the second direction (Y direction), passing through the center SPc between the driving substrate-side electrodes.

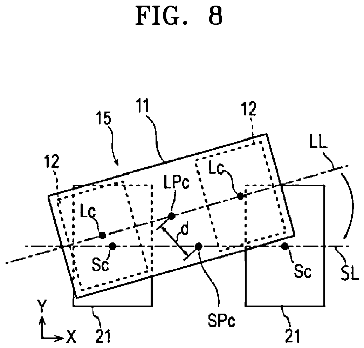

FIG. 8 is a plan view for describing a rotation shift amount according to an embodiment of the disclosure.

Referring to FIG. 8, according to an embodiment of the disclosure, a line SL connecting between centers Sc of the adjacent driving substrate-side electrodes 21, and a line LL connecting between centers Lc of the adjacent device-side electrodes 12 may be expressed. The rotation shift amount according to an embodiment of the disclosure may be an amount of rotation by which the micro-LED 15 with the line SL inclined with respect to the line LL rotates to be at the correct position.

Like the shift amount d, the rotation shift amount according to an embodiment of the disclosure may also be expressed by using the distance (LPc-SPc) between the center SPc between the adjacent driving substrate-side electrodes 21 and the center LPc between the adjacent device-side electrodes 12. For example, for the preferred correct position, the rotation shift amount may also be d = 0. In addition, a tolerance may also be set for the rotation shift amount for the final connection position of the micro-LED 15. For example, the tolerance for the rotation shift amount for the final connection position may be less than LPc - SPc = $\pm 1$ $\mu$m. In addition, the rotation shift amount according to an embodiment of the disclosure may be expressed as an angle of rotation. For example, the angle of rotation may be measured as an angle formed between the line LL and the line SL.

FIG. 9 is a plan view illustrating a state in which the device-side electrode 12 and the driving substrate-side electrode 21 are connected to each other, when viewed from the micro-LED 15, according to an embodiment of the disclosure.

Referring to FIG. 9, an inter-electrode distance z of the adjacent driving substrate-side electrodes 21 according to an embodiment of the disclosure may exceed an inter-electrode distance c of the adjacent device-side electrodes 12. For example, the placement of the electrodes may be performed according to the following placement conditions. In this case, a maximum length w of the micro-LED 15 may be 100 $\mu$m or less.

The electrode placement conditions are as follows:

(a) the center Lc of the device-side electrode 12 is in a region that overlaps the driving substrate-side electrode 21;
(b) the center Sc of the driving substrate-side electrode 21 is in a region that overlaps the device-side electrode 12;
(c) the shift amount d is determined such that the center Lc of the device-side electrode 12 is in a region that overlaps the driving substrate-side electrode 21;
(d) when the center Lc of one device-side electrode 12 is at an end of the driving substrate-side electrode 21 in the Y direction, the center Lc of the other device-side electrode 12 is in a region that overlaps the driving substrate-side electrode 21; and
(e) when rotation occurs at the center of an electrode, an electrode on the other side is spaced apart therefrom.

Furthermore, the size of each of the device-side electrode 12 and the driving substrate-side electrode 21 may be determined according to Equations (1) to (6) below:

(1) $d < x - (a + cz) / 2$: allowable minimum length in first direction for shift amount d;
(2) $y / 2 > d$: allowable minimum length in second direction for shift amount d;
(3) $\surd(x^2 + y^2) < a + c$: limitations on x and y that maximize possible angle of rotation;
(4) $z < a + c$: maximum inter-electrode gap;

(5) x < 2a + cz: maximum length in first direction; and

(6) y < a + c: maximum length in second direction that maximizes possible angle of rotation.

In Equations (1) to (6), the direction in which the device-side electrode 12 and the driving substrate-side electrode 21 are arranged is the first direction (X), the direction orthogonal to the first direction X is the second direction (Y), a denotes the length of the device-side electrode 12 in the X direction, b denotes the length in the Y direction, c denotes the distance between the device-side electrodes 12, x denotes the length of the driving substrate-side electrode 21 in the X direction, y denotes the length in the Y direction, z denotes the distance between the driving substrate-side electrodes 21, and d denotes the difference between the center between the adjacent device-side electrodes 12 and the center between the adjacent driving substrate-side electrodes 21.

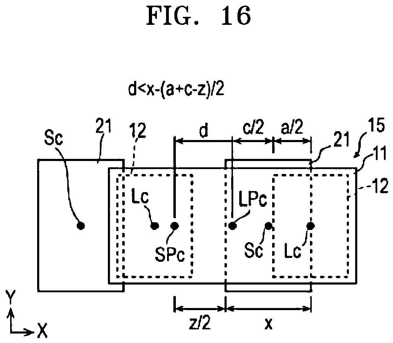

Equations (1) to (6) described above are described below with reference to FIGS. 16 to 33.

However, the disclosure is not limited thereto, and the size of each of the device-side electrode 12 and the driving substrate-side electrode 21 does not need to satisfy all of Equations above. For example, the size of each of the device-side electrode 12 and the driving substrate-side electrode 21 may be determined according to at least Equations (1), (2), (4), (5) and (6), accordingly, when misalignment occurs in the direction of rotation of the micro-LED 15, a self-alignment effect is easily induced, and thus defects due to the misalignment in the direction of rotation may be reduced. As another example, the size of each of the device-side electrode 12 and the driving substrate-side electrode 21 may be determined according to at least Equations (3) to (6). Accordingly, when misalignment in a linear direction (the X, Y, or XY direction) occurs, a self-alignment effect is easily induced, and thus defects caused by the misalignment in the linear direction may be reduced.

In addition, according to an embodiment of the disclosure, a weight for each of Equations (1) to (6) may be set according to circumstances. For example, Equations (1) and (2) may be applied to misalignment in a straight line. In addition, Equation (3) may be applied to misalignment in a direction of rotation. For example, in a process of manufacturing a display apparatus, misalignment in a linear direction may occur more frequently than misalignment in a direction of rotation. In this case, the largest weight may be applied to Equations (1) and (2), the second-largest weight may be applied to Equation (3), and the third-largest weight may be applied to Equations (4) to (6).

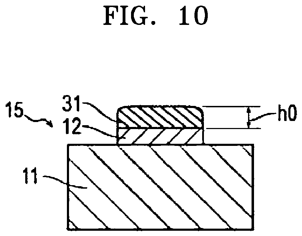

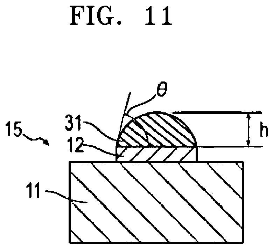

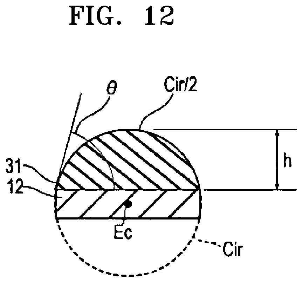

FIG. 10 is a cross-sectional view illustrating a state in which a solder layer (a solder material) 31 is deposited on the device-side electrode 12, according to an embodiment of the disclosure. FIG. 11 is a cross-sectional view illustrating a state of the solder layer 31 in pressureless heating (reflow), according to an embodiment of the disclosure, and FIG. 12 is an enlarged cross-sectional view of the device-side electrode 12 having undergone pressureless heating (reflow), according to an embodiment of the disclosure.

The solder layer 31 according to an embodiment of the disclosure may be deposited on the device-side electrode 12 as, for example, a solder bump or the like. For example, the solder layer 31 may be placed between the device-side electrode 12 and the driving substrate-side electrode 21, then undergo a pressureless heating process to connect between the device-side electrode 12 and the driving substrate-side electrode 21, and then be cured to form the metal layer 35.

Referring to FIG. 10, according to an embodiment of the disclosure, the surface of the solder layer 31 having been deposited on the device-side electrode 12 may be substantially flat.

As illustrated in FIG. 11, the pressureless heating causes the solder layer 31 to be in the shape of a droplet having an angle $\theta$ on the electrode. The solder layer 31 having the shape of a droplet may have a cross section in a substantially semicircular shape Cir/2 on the device-side electrode 12 as illustrated in FIG. 12. The cross section in the semicircular shape Cir/2 may be a part of a circle Cir centered on a center Ec of the device-side electrode 12. According to an embodiment of the disclosure, the height of the solder layer 31 having the shape of a droplet may be denoted by h.

In a three-dimensional view, the solder layer 31 is a part of a sphere centered on the center Ec of the device-side electrode 12, and may have a substantially hemispherical shape on the device-side electrode 12. The angle $\theta$ illustrated in FIG. 11 is an angle between the surface of the device-side electrode 12 and a tangent line to the surface of the droplet at one end of the surface of the device-side electrode 12.

According to an embodiment of the disclosure, a volume V of the solder layer 31 having melted (into a molten state) and then cured may be determined depending on a length a in the first direction and a length b in the second direction of the device-side electrode 12, according to Equation (7) below.

$$(7)\ 0.059 \times a \times b^2 < V < 0.393 \times a \times b^2$$

According to an embodiment of the disclosure, in order to obtain the solder volume V, a height $h_0$ (also referred to as a layer thickness) of the solder layer 31 having deposited on the device-side electrode 12 may be determined according to Equation (8) below. In addition, the angle $\theta$ of the solder layer 31 in the molten state may be $20° < \theta \le 90°$.

$$(8) \quad h0=b/4\times(\theta-\cos\theta\sin\theta)/(\sin\theta)\,^{\wedge}\,2$$

There is no significant difference in the properties of a material included in the solder layer 31 according to an embodiment of the disclosure between before and after the pressureless heating. Therefore, it may be considered that there is no difference in the volume V of the solder layer 31 between before the pressureless heating, i.e., when the solder layer 31 has been deposited on the device-side electrode 12, and when the solder layer 31 has melted by pressureless heating and then cured. The angle $\theta$ of the solder layer 31 in the molten state may be $20° < \theta \leq 90°$. In this case, the height h0 of the solder layer 31 may be determined according to Equation (9) below.

$$(9) \quad 0.059\times b<h0<0.393\times b$$

According to an embodiment of the disclosure, the volume V of the solder layer 31 is determined according to Equation (7), and thus, when the micro-LED 15 is connected, the probability of the solder material being pushed out from the electrodes, resulting in a short circuit between the electrodes, may be reduced. In addition, the angle $\theta$ of the solder layer 31 in the molten state may be $20° < \theta \leq 90°$. By keeping the angle $\theta$ within the above range, when the micro-LED 15 is connected, the probability of the solder material being pushed out from the electrodes, resulting in a short circuit between the electrodes, may be reduced.

[Self-alignment effect]

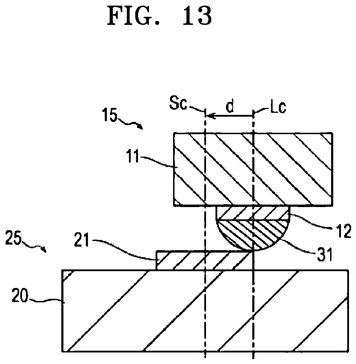

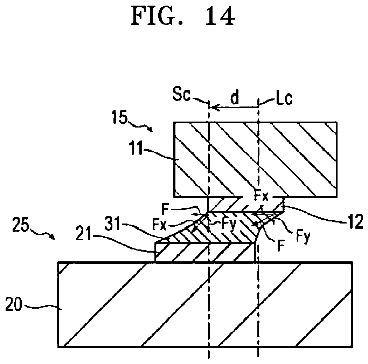

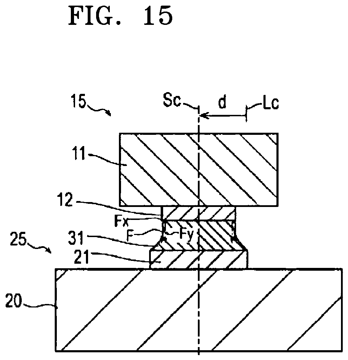

FIG. 13 is a cross-sectional view for describing a positional relationship between the solder layer 31 in the molten state and the driving substrate-side electrode 21 when a self-alignment effect occurs, according to an embodiment of the disclosure. FIG. 14 is a cross-sectional view for describing a surface tension F of the solder layer 31 in the molten state according to an embodiment of the disclosure. FIG. 15 is a cross-sectional view for describing a state in which the device-side electrode 12 is connected to the driving substrate-side electrode 21, according to an embodiment of the disclosure.

According to an embodiment of the disclosure, the solder layer 31 in the molten state may have a semicircular cross-section as described above. For example, the apex of the semicircle may coincide with the position of the center Lc of the device-side electrode 12. As illustrated in FIG. 13, when the center Lc of the device-side electrode 12 is in a region that overlaps the driving substrate-side electrode 21, the apex of the solder layer 31 may also be in a region that overlaps the driving substrate-side electrode 21. Accordingly, the apex of the solder layer 31 in the molten state may be in contact with the driving substrate-side electrode 21.

According to an embodiment of the disclosure, the solder layer 31 in the molten state in contact with the driving substrate-side electrode 21 may flow to be on the surface of the driving substrate-side electrode 21 as illustrated in FIG. 14. At this time, the surface tension F may act on the solder layer 31 in the molten state. The surface tension F may include a horizontal component Fx and a vertical component Fy.

When the micro-LED 15 according to an embodiment of the disclosure is in a position that is not aligned with the correct position in the transfer process, the micro-LED 15 may be moved toward the correct position by the horizontal component Fx of the surface tension F. Referring to FIGS. 13 to 15, the center Lc of the device-side electrode 12 according to an embodiment of the disclosure may move toward the center Sc of the driving substrate-side electrode 21. That is, the micro-LED 15 in the position that is not aligned with the correct position as illustrated in FIG. 13 may be moved to the correct position by the surface tension F of the solder layer 31 as illustrated in FIG. 15. According to an embodiment of the disclosure, when the micro-LED 15 is moved to the correct position, the horizontal component Fx of the surface tension F reaches a state of balance, and accordingly, the position of the micro-LED 15 may be fixed. That is, the micro-LED 15 may be self-aligned.

As the thickness of the solder layer 31 according to an embodiment of the disclosure increases, the amount of the solder layer 31 in the molten state increases, thus the surface tension increases, and thus the self-alignment effect may be easily secured. However, when the amount of the solder layer 31 is excessive, the excess of the solder layer 31 may be pushed out of the driving substrate-side electrode 21. Therefore, as described above, the volume V of the solder layer 31 may be determined according to Equation (7), and the height h0 of the solder layer 31 may be determined according to Equation (8) or (9).

FIG. 16 is a plan view for describing self-alignment for linear misalignment according to an embodiment of the disclosure.

Referring to FIG. 16, when $d < x - (a + cz) / 2$, the length of each of the device-side electrode 12 and the driving substrate-side electrode 21 may be determined according to Equation (1) described above. Accordingly, in the first direction (X direction), the apex of the solder layer 31 in the molten state may be in a region that overlaps the driving substrate-side electrode 21. Accordingly, the solder layer 31 in the molten state may be in contact with the driving substrate-side electrode 21, and may flow to be arranged. Accordingly, a self-aligning effect occurs and thus causes the micro-LED 15 to move to the correct position in the first direction (X direction).

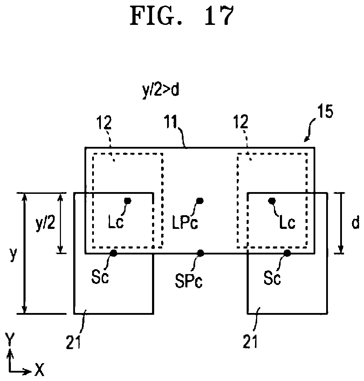

FIG. 17 is a plan view for describing self-alignment for linear misalignment according to an embodiment of the disclosure.

Referring to FIG. 17, when y / 2 > d, the length of each of the device-side electrode 12 and the driving substrate-side electrode 21 may be determined according to Equation (2) described above. Accordingly, in the second direction (Y direction), the apex of the solder layer 31 in the molten state may be in a region that overlaps the driving substrate-side electrode 21. Accordingly, the solder layer 31 in the molten state may be in contact with the driving substrate-side electrode 21, and may flow to be arranged. Accordingly, a self-alignment effect occurs and causes the micro-LED 15 to move to the correct position in the second direction (Y direction).

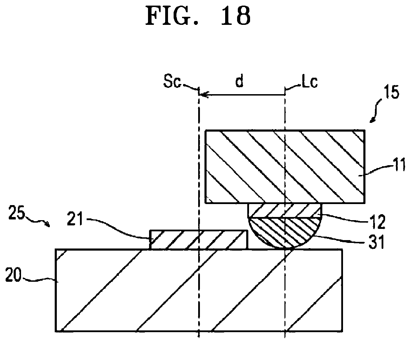

FIG. 18 is a cross-sectional view for describing a positional relationship between the solder layer 31 in the molten state and the driving substrate-side electrode 21 when there is a possibility that no self-alignment effect occurs, according to an embodiment of the disclosure.

According to an embodiment of the disclosure, the solder layer 31 in the molten state may have a semicircular shape as described above. For example, the apex of the semicircle may coincide with the position of the center Lc of the device-side electrode 12. As illustrated in FIG. 18, when the center Lc of the device-side electrode 12 is out of a region that overlaps the driving substrate-side electrode 21, the apex of the solder layer 31 may be in a region that does not overlap the driving substrate-side electrode 21. Accordingly, the apex of the solder layer 31 in the molten state may not be in contact with the driving substrate-side electrode 21. For example, when the height of the solder layer 31 is less than a certain range, the apex of the solder layer 31 in the molten state may not be in contact with the driving substrate-side electrode 21. In this case, the solder layer 31 in the molten state cannot flow to the driving substrate-side electrode 21 to be arranged. Therefore, no self-alignment effect occurs in the state illustrated in FIG. 18.

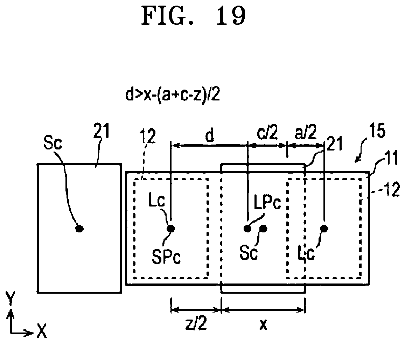

FIG. 19 is a plan view for describing self-alignment for linear misalignment according to an embodiment of the disclosure.

Referring to FIG. 19, when d > x - (a + c - z) / 2, the length of each of the device-side electrode 12 and the driving substrate-side electrode 21 cannot be determined according to Equation (1) described above. Accordingly, in the first direction (X direction), the apex of the solder layer 31 in the molten state cannot be in a region that overlaps the driving substrate-side electrode 21. Accordingly, the solder layer 31 in the molten state is not in contact with the driving substrate-side electrode 21, and thus cannot flow to be arranged. Accordingly, no self-alignment effect occurs in the state illustrated in FIG. 19, and thus the micro-LED 15 cannot move to the correct position in the first direction (X direction). For example, the above-described state may occur when, for example, misalignment of the transfer position of the micro-LED in the transfer process is out of a certain range.

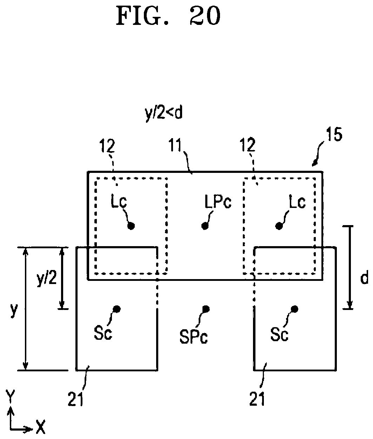

FIG. 20 is a plan view for describing linear misalignment according to an embodiment of the disclosure.

Referring to FIG. 20, when y / 2 < d, the length of each of the device-side electrode 12 and the driving substrate-side electrode 21 cannot be determined according to Equation (2) described above. Accordingly, in the second direction (Y direction), the apex of the solder layer 31 in the molten state cannot be in a region that overlaps the driving substrate-side electrode 21. Accordingly, the solder layer 31 in the molten state is not in contact with the driving substrate-side electrode 21, and thus cannot flow to be arranged. Accordingly, no self-alignment effect occurs in the state illustrated in FIG. 20, and thus the micro-LED 15 cannot move to the correct position in the second direction (Y direction). For example, the above-described state may occur when, for example, misalignment of the transfer position of the micro-LED in the transfer process is out of a certain range.

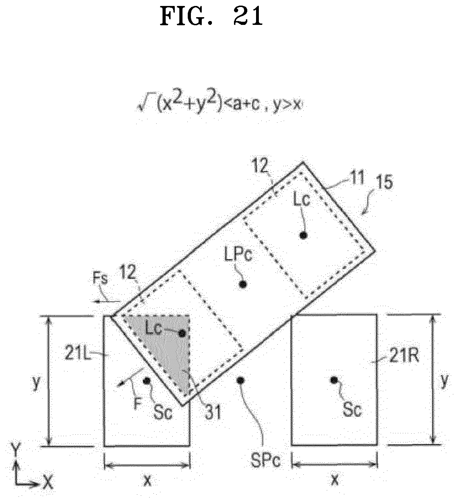

FIGS. 21 to 24 are plan views for describing self-alignment for rotational misalignment according to an embodiment of the disclosure.

Referring to FIGS. 21 to 24, an arrow F represents the direction of a force acting on the micro-LED 15, an arrow Fs represents the direction of a force acting as the solder layer 31 flows to be arranged, and an arrow Fr represents the direction of a rotational force.

In the transfer process according to an embodiment of the disclosure, as illustrated in FIG. 21, the micro-LED 15, which is misaligned and thus inclined with respect to the driving substrate 25, may be transferred.

According to an embodiment of the disclosure, when a length x in the first direction (the X direction) and a length y in the second direction (the Y direction) of the driving substrate-side electrode 21 satisfy $\sqrt{(x^2 + y^2)} < a + c$ (wherein y > x), the length of each of the device-side electrode 12 and the driving substrate-side electrode 21 may be determined according to Equation (3).

For example, a force in a direction Fs created by the flow of the solder layer 31 and a force in a direction F created by the surface tension of the solder layer 31 in the molten state act on the micro-LED 15. Accordingly, as illustrated in FIG. 21, the micro-LED 15 according to an embodiment of the disclosure may move toward the center Lc of the second driving substrate-side electrode 21L that is in contact with the solder layer 31.

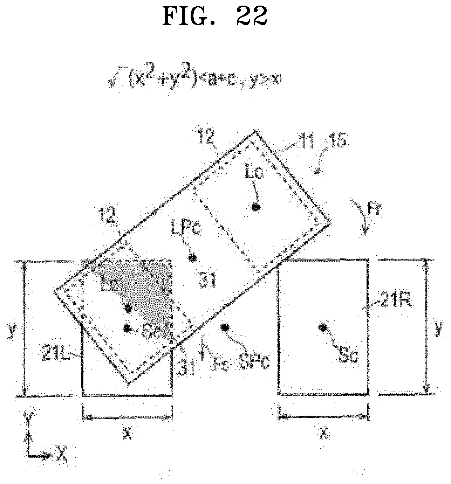

Next, a force in a direction Fr may be applied to the micro-LED 15 to cause it to rotate clockwise as illustrated in FIG. 22.

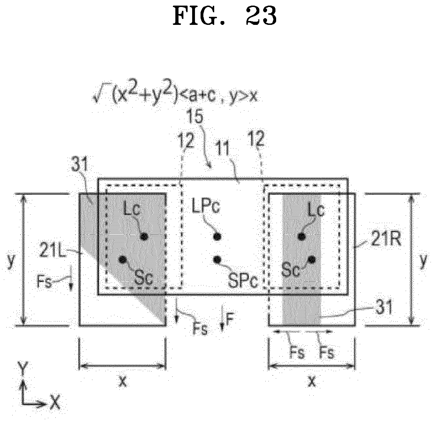

As illustrated in FIG. 23, as the micro-LED 15 rotates, the direction in which the adjacent device-side electrodes 12 are arranged may be parallel with the direction in which the adjacent driving substrate-side electrodes 21 are arranged.

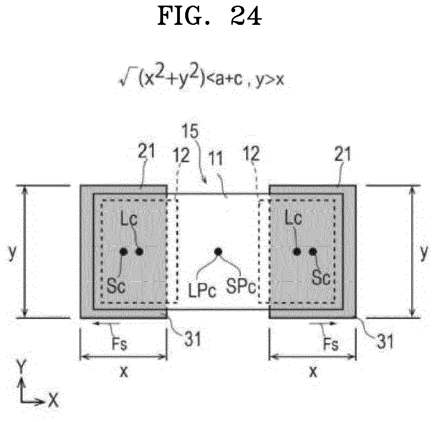

Next, as illustrated in FIG. 24, the micro-LED 15 according to an embodiment of the disclosure may move to the correct position such that the two device-side electrodes 12 overlap the two corresponding driving substrate-side electrodes 21, respectively. At this time, as illustrated in FIG. 24, the solder layer 31 flowing to be arranged creates forces in the direction Fs acting toward each other between the device-side electrode 12 and the driving substrate-side electrode 21. Accordingly, the micro-LED 15 may stop rotating, and the device-side electrode 12 and the driving substrate-side electrode 21 may be connected thereto at the correct position.

However, the disclosure is not limited thereto, and in an actual manufacturing process, such forces in the directions F, Fs, and Fr act in a complex manner and may not act in the above-described order. For example, during an actual manufacturing process, a self-alignment effect may occur when the length of each of the device-side electrode 12 and the driving substrate-side electrode 21 satisfies Equation (3), and accordingly, the micro-LED 15 may be aligned to the position illustrated in FIG. 24.

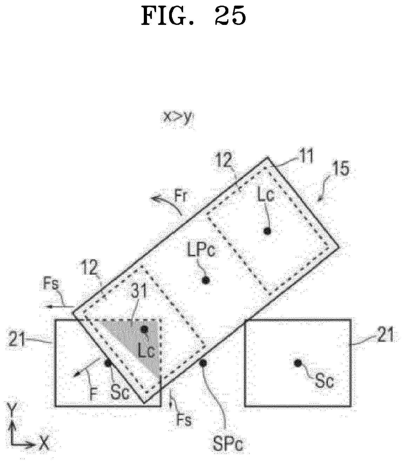

FIGS. 25 to 27 are plan views for describing self-alignment for rotational misalignment according to an embodiment of the disclosure.

Referring to FIGS. 25 to 27, the arrow F represents the direction of a force acting on the micro-LED 15, the arrow Fs represents the direction of a force acting as the solder layer 31 flows to be arranged, and the arrow Fr represents the direction of a rotational force.

In the transfer process according to an embodiment of the disclosure, as illustrated in FIG. 25, the micro-LED 15, which is misaligned and thus inclined with respect to the driving substrate 25, may be transferred. In this case, a force in the direction F acts on the micro-LED 15. In addition, as the solder layer 31 flows to be arranged, a force in the direction Fs may also act on the micro-LED 15.

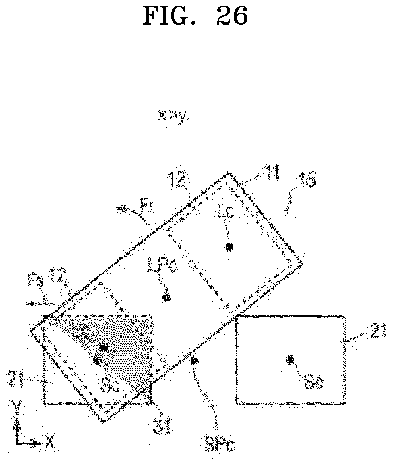

In this case, the length x in the first direction (the X direction) and the length y in the second direction (the Y direction) of the driving substrate-side electrode 21 satisfy x>y, and accordingly the lengths of the device-side electrode 12 and the driving substrate-side electrode 21 do not satisfy Equation (3). Accordingly, as illustrated in FIGS. 25 and 26, a rotational force in the direction Fr acts on the micro-LED 15 to cause it to rotate counterclockwise.

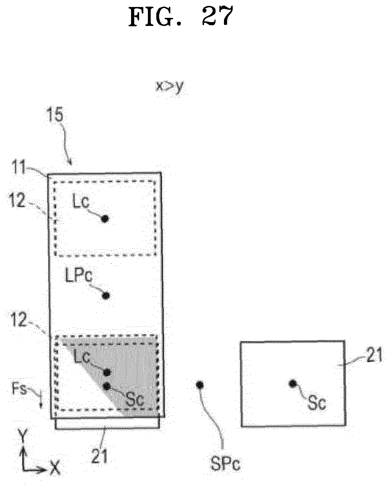

As illustrated in FIG. 27, when the micro-LED 15 rotates counterclockwise, the direction in which the adjacent device-side electrodes 12 are arranged is aligned parallel to the second direction (the y direction), and the adjacent device-side electrodes 12 cannot be connected to one of the adjacent driving substrate-side electrodes 21.

FIG. 18 is a plan view for describing self-alignment for linear misalignment according to an embodiment of the disclosure.

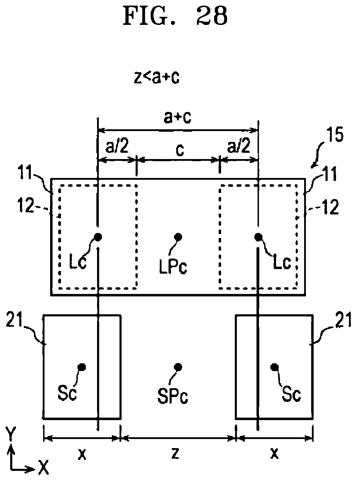

Referring to FIG. 28, when z < a + c, the length of each of the device-side electrode 12 and the driving substrate-side electrode 21 may be determined according to Equation (4) described above. In this case, the center Lc of the device-side electrode 12 may be in a region that overlaps the driving substrate-side electrode 21. Accordingly, in the first direction (X direction), the apex of the solder layer 31 in the molten state may be in a region that overlaps the driving substrate-side electrode 21. Accordingly, the solder layer 31 in the molten state may be in contact with the driving substrate-side electrode 21, and thus flow to be arranged. Accordingly, a self-aligning effect may occur and thus cause the micro-LED 15 to move to the correct position in the first direction (X direction).

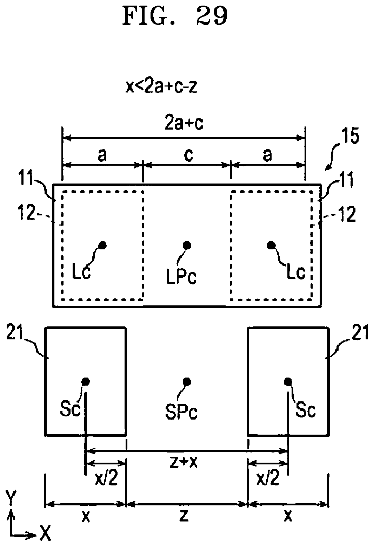

FIG. 29 is a plan view for describing self-alignment for linear misalignment according to an embodiment of the disclosure.

Referring to FIG. 29, when x < 2a + c - z, the length of each of the device-side electrode 12 and the driving substrate-side electrode 21 may be determined according to Equation (5) described above. In this case, the center Sc of the driving substrate-side electrode 21 may be in a region that overlaps the device-side electrode 12. Accordingly, in the first direction (X direction), the apex of the solder layer 31 in the molten state may be in a region that overlaps the driving substrate-side electrode 21. Accordingly, the solder layer 31 in the molten state may be in contact with the driving substrate-side electrode 21, and thus flow to be arranged. Accordingly, a self-aligning effect may occur and thus cause the micro-LED 15 to move to the correct position in the first direction (X direction).

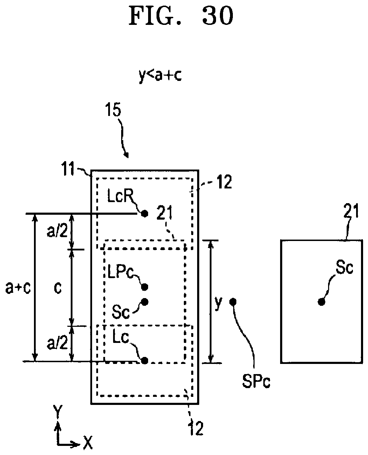

FIG. 30 is a plan view for describing self-alignment for rotational misalignment according to an embodiment of the disclosure.

Referring to FIG. 30, when y < a + c, the length of each of the device-side electrode 12 and the driving substrate-side electrode 21 may be determined according to Equation (6) described above. In this case, a center LcR of one of the device-side electrodes 12 may be in a region that does not overlap the driving substrate-side electrode 21. As the length of each of the device-side electrode 12 and the driving substrate-side electrode 21 is determined according to Equation (6), a self-alignment effect occurs and thus causes the micro-LED 15 to rotate and move to the correct position.

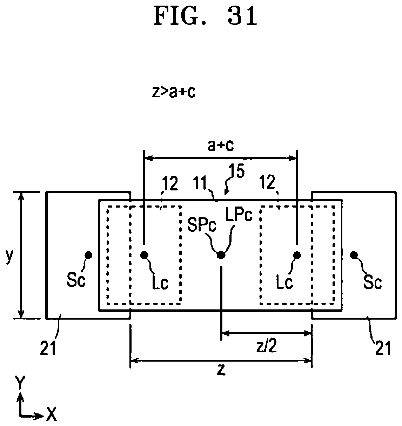

FIG. 31 is a plan view for describing self-alignment for linear misalignment according to an embodiment of the disclosure.

Referring to FIG. 31, when z > a + c, the length of each of the device-side electrode 12 and the driving substrate-side electrode 21 may not be determined according to Equation (4) described above. In this case, the center Lc of the device-side electrode 12 may be in a region that does not overlap the driving substrate-side electrode 21. Accordingly, no self-aligning effect may not occur and thus the micro-LED 15 may not move to the correct position in the first direction (X direction).

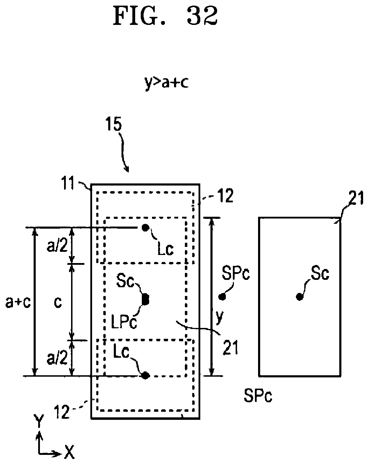

FIG. 32 is a plan view for describing self-alignment for linear misalignment according to an embodiment of the disclosure.

Referring to FIG. 32, when z + x > 2a + c, the length of each of the device-side electrode 12 and the driving substrate-side electrode 21 may not be determined according to Equation (5) described above. In this case, the center Sc of the driving substrate-side electrode 21 may be in a region that does not overlap the device-side electrode 12. Accordingly, no self-aligning effect may not occur and thus the micro-LED 15 may not move to the correct position in the first direction (X direction).

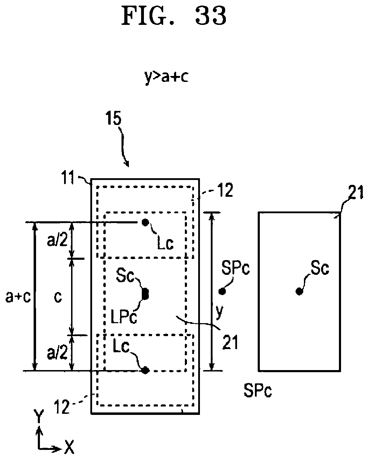

FIG. 33 is a plan view for describing self-alignment for rotational misalignment according to an embodiment of the disclosure.

Referring to FIG. 33, when y > a + c, the length of each of the device-side electrode 12 and the driving substrate-side electrode 21 may not be determined according to Equation (6) described above. In this case, the centers Lc of the device-side electrodes 12 may be in regions that overlap one of the driving substrate-side electrodes 21. Accordingly, no self-aligning effect with rotation may not occur and thus the micro-LED 15 may not move to the correct position.

According to an embodiment of the disclosure, the micro-LED 15 may be efficiently aligned on the driving substrate 25 by a self-alignment effect. In addition, according to an embodiment of the disclosure, by designing the driving substrate-side electrode 21 considering the arrangement and size of the device-side electrode 12 of the micro-LED 15, even the micro-LED 15 that has been misaligned when connected to the driving substrate 25 may be aligned to a certain position by a self-alignment effect (or it is possible to increase the number of micro-LEDs 15 aligned within a certain range around a certain position).

[Method of manufacturing the display apparatus 10]

Hereinafter, a method of manufacturing the display apparatus 10 is described.

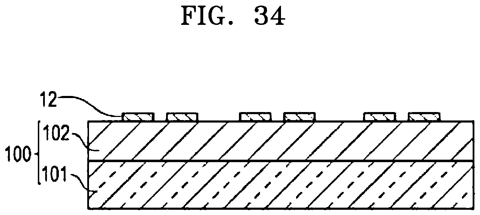

FIGS. 34 to 44 are cross-sectional views for describing the method of manufacturing the display apparatus 10 according to an embodiment of the disclosure.

(Micro-LED manufacturing process)

Referring to FIG. 34, the method of manufacturing the display apparatus 10 according to an embodiment of the disclosure may include forming, on a sapphire substrate 101, a semiconductor layer 102 that is to become the micro-LED 15 (a light-emitting device). For example, the semiconductor layer 102 may emit light of a certain wavelength as an LED. The semiconductor layer 102 may be a GaN-based semiconductor that is grown on the sapphire substrate 101. For example, at this stage, the semiconductor layer 102 is not divided into the individual micro-LED 15s. According to an embodiment of the disclosure, the sapphire substrate 101 and the semiconductor layer 102 may be collectively referred to as an initial substrate 100. The sapphire substrate 101 may be, for example, a 4-inch wafer. However, the disclosure is not limited thereto, and the wafer size of the sapphire substrate 101 is not limited to 4 inches.

On the semiconductor layer 102, an electrode may be arranged at a position corresponding to each micro-LED 15 after division.

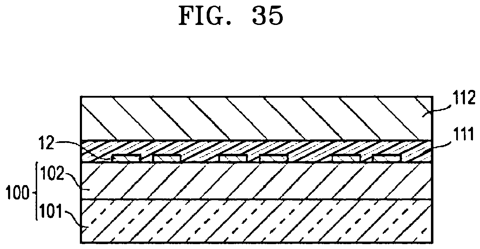

Next, referring to FIG. 35, a relay substrate 112 may be arranged, by using a transfer resin layer 111, on a surface of the initial substrate 100 on which the device-side electrodes 12 are formed. For example, the transfer resin layer 111 may be formed on one surface of the relay substrate 112 by using spin coating or the like. In this case, the one surface of the relay substrate 112 may be a surface facing the initial substrate 100. Next, the initial substrate 100 and the relay substrate 112 may be bonded to each other. Next, the transfer resin layer 111 may be cured by heat treatment such that the initial substrate 100 and the relay substrate 112 are fixedly bonded to the transfer resin layer 111.

The relay substrate 112 according to an embodiment of the disclosure may include, for example, a quartz glass substrate. The transfer resin layer 111 may include, for example, one or more of polyimide resin, acrylic resin (e.g., polymethyl methacrylate (PMMA)), epoxy resin, polypropylene (PP) resin, polycarbonate resin, and acrylonitrile butadiene styrene (ABS) resin. In addition, the transfer resin layer 111 may include a thermal-curing agent in addition to the above-described resin material. However, the disclosure is not limited thereto, and the transfer resin layer 111 may also include other thermosetting resins. For example, the transfer resin layer 111 may have an absorbance of 80 % or greater in a wavelength of laser light used in laser lift-off to be described below.

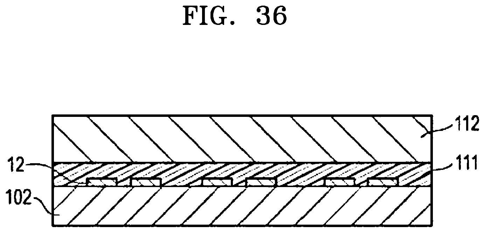

Next, referring to FIG. 36, the sapphire substrate 101 may be separated from the semiconductor layer 102. For example, the sapphire substrate 101 may be separated from the semiconductor layer 102 by using laser lift-off. For example, laser light of an ultraviolet wavelength may be emitted from the side of the sapphire substrate 101 to irradiate the entire surface thereof. The sapphire substrate 101 may be separated from the semiconductor layer 102 by the laser light irradiation. For example, as the laser light, KrF excimer laser having a wavelength of 248 nm may be used. However, the disclosure is not limited thereto, and laser having any wavelength may be used as long as the sapphire substrate 101 may be separated from the semiconductor layer 102.

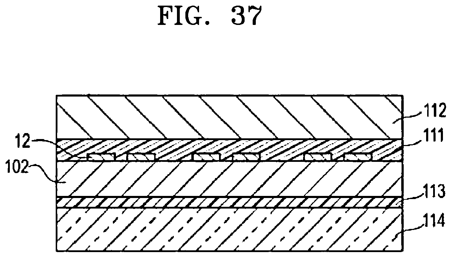

Next, referring to FIG. 37, a source substrate 114 may be bonded to the semiconductor layer 102 with a release layer 113 therebetween. The release layer 113 is also referred to as a dynamic release layer (DRL). According to an embodiment of the disclosure, a resin material that is to become the release layer 113 may be arranged on the semiconductor layer 102 by using spin coating. Next, the source substrate 114 may be bonded to the resin material on the semiconductor layer 102. Next, the resin material is cured by heat treatment to form the release layer 113, and the source substrate 114 may be fixedly bonded to the release layer 113.

According to an embodiment of the disclosure, the source substrate 114 may transmit a wavelength of laser light used in a transfer process to be described below. For example, the source substrate 114 may include a quartz glass substrate. The quartz glass substrate may be, for example, the same size as or larger than the sapphire substrate 101 described above. For example, when the sapphire substrate 101 is a 4-inch wafer, the source substrate 114 (a quartz glass substrate) may also have a 4-inch wafer size.

For example, the resin material included in the release layer 113 may include one or more of polyimide resin, acrylic resin (e.g., polymethyl methacrylate (PMMA)), epoxy resin, polypropylene (PP) resin, polycarbonate resin, and acrylonitrile butadiene styrene (ABS) resin, and the resin material may be mixed with a thermal-curing agent. However, the disclosure is not limited thereto, and any thermosetting resin may be used as the resin material. The resin material that becomes the release layer 113 may have an absorbance of 80 % or greater in a certain wavelength of laser light used in a transfer process to be described below. By using the resin material having an absorbance of 80 % or greater in the transfer process, the micro-LED 15 may be easily separated by laser ablation to be described below.

According to an embodiment of the disclosure, the amount of the resin material applied to the release layer 113 may be adjusted such that the thickness of the release layer 113 after being cured is 0.1 $\mu$m to 2 $\mu$m.

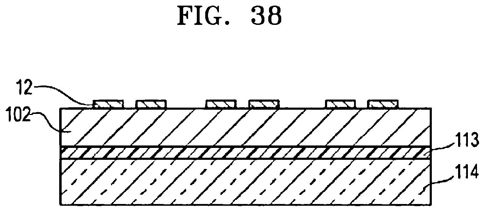

Next, referring to FIG. 38, the relay substrate 112 is removed from the semiconductor layer 102. For example, the relay substrate 112 may be removed by using laser lift-off. For example, laser light having an ultraviolet wavelength may be emitted to irradiate the entire surface of the relay substrate 112. Accordingly, the transfer resin layer 111 may be melted, and the relay substrate 112 may be separated from one surface of the device-side electrode 12 and then removed. The transfer resin layer 111 remaining on one surface of the device-side electrode 12 is removed by using cleaning. The laser light used in this operation may be a KrF excimer laser having a wavelength of 248 nm. However, the disclosure is not limited thereto, and the wavelength of the laser light may be appropriately determined depending on the resin material used as the transfer resin layer 111.

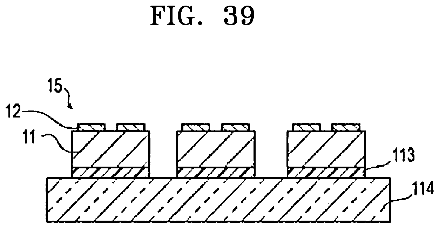

Next, referring to FIG. 39, the semiconductor layer 102 according to an embodiment of the disclosure may be divided into a plurality of micro-LEDs 15. For example, in order to divide the semiconductor layer 102 into the plurality of micro-LEDs 15, a photoresist may be formed on the semiconductor layer 102 and then patterned by using photolithography, and the semiconductor layer 102 may be divided into the micro-LEDs 15 by dry etching using the patterned photoresist as a mask.

Next, by using the micro-LEDs 15 as a mask, the release layer 113 may also be patterned to have the same shape as the micro-LEDs 15. For example, the dry etching may be reactive ion etching (RIE) that is anisotropic etching. The chip shape of the micro-LED 15 may be rectangular in a plan view of the surface on which the device-side electrode 12 is formed.

For example, in the micro-LED 15, the length of the longest side of the rectangle may be, for example, 100 $\mu$m or less. In addition, the height of the micro-LED 15, that is, the thickness of the semiconductor layer 102 may be, for example, 500 $\mu$m or less. Therefore, the dimensions of the micro-LED 15 may be length $\times$ width $\times$ height = (100 $\mu$m or less) $\times$ (100 $\mu$m or less) $\times$ (500 $\mu$m or less). In this case, the lower limit of each of the length, width and height is not particularly limited, and may be any value as long as the micro-LED 15 may be manufactured.

In addition, an interval between the micro-LEDs 15 arranged on the source substrate 114 may be set to any minimum value as long as the micro-LEDs 15 may be manufactured. For example, the arrangement pitch between the micro-LEDs 15 may be determined depending on the size of the micro-LEDs 15. For example, the arrangement pitch between the micro-LEDs 15 may be 200 $\mu$m or less. Here, the arrangement pitch may be, for example, the distance between the centers of adjacent micro-LEDs 15 or the distance between edges of adjacent micro-LEDs 15 in the same direction.

(Metal layer deposition process)

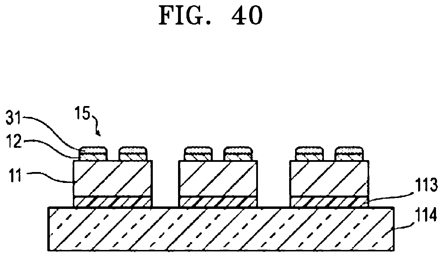

Next, referring to FIG. 40, the solder layer 31 may be deposited on each device-side electrode 12 according to an embodiment of the disclosure. A well-known process may be used for the deposition of the solder layer 31. For example, one or more of a ball bump method, a solder paste method, a press method, and a plating method may be used. Also, for example, self-assembly anisotropic conductive paste (SAP) that is anisotropic conductive paste may be used.

According to an embodiment of the disclosure, a source substrate structure may be provided in which the micro-LED 15 is supported on the source substrate 114 by using the release layer 113 by using the above-described process.

(Driving substrate manufacturing process)

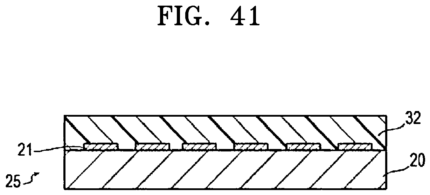

Next, referring to FIG. 41, the driving substrate 25 according to an embodiment of the disclosure may be manufactured. For example, the driving substrate 25 may have a size corresponding to the size of the display apparatus 10 to be manufactured.

The driving substrate 25 may include an electrode to be connected to the device-side electrode 12, along with a thin-film transistor (TFT) or a wiring necessary to supply power to the micro-LED 15. A part of a metal wiring formed on the driving substrate 25 may be used as the driving substrate-side electrode 21, or a metal pad connected to a wiring may be used as the driving substrate-side electrode 21.

Next, a flux 32 may be applied to the surface of the driving substrate 25 on which the driving substrate-side electrode 21 is formed.

The flux according to an embodiment of the disclosure may be applied to one surface of the driving substrate 25, for example, the entire surface on which the driving substrate-side electrode 21 is formed, by using a lamination method or a printing method. The thickness of the flux may be, for example, 1 $\mu$m to 50 $\mu$m. A heating process may be used to connect the micro-LED 15 to the driving substrate 25. For example, as the flux 32 has a thickness of 1 $\mu$m to 50 $\mu$m, the solder layer 31 formed on the device-side electrode 12 may reach the driving substrate-side electrode 21 in a pressureless heating process to be described below. Accordingly, the driving substrate 25 according to an embodiment of the disclosure may be provided.

(Transfer process)

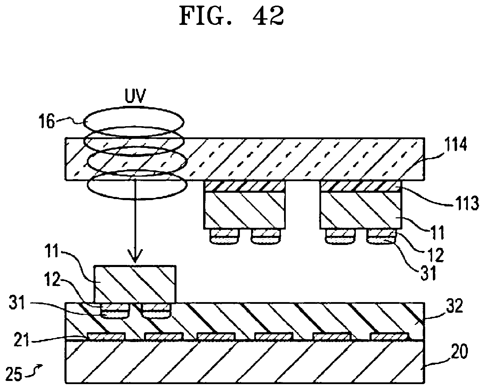

Next, referring to FIG. 42, the micro-LED 15 according to an embodiment of the disclosure may be transferred to a certain position on the driving substrate 25.

According to an embodiment of the disclosure, the micro-LED 15 may be transferred by using laser ablation. For example, the position of the source substrate 114 may be determined such that a position at which one micro-LED 15 is connected to the driving substrate 25 is aligned. At this time, the position of the source substrate 114 may be determined depending on the position at which the device-side electrode 12 of one micro-LED 15 may be connected to the corresponding driving substrate-side electrode 21 to drive the micro-LED 15.

Next, laser light 16 having a certain wavelength (e.g., an ultraviolet (UV) wavelength) is emitted from the side of the source substrate 114 toward the micro-LED 15. Due to the emission of the laser light 16, the release layer 113 that adheres the micro-LED 15 to the source substrate 114 may be dissolved and thus the micro-LED 15 may be released toward the driving substrate 25. The released micro-LED 15 may be caught by the flux 32 on the driving substrate 25.

For example, the laser light 16 may be KrF excimer laser having a certain wavelength, for example, a wavelength of 248 nm. However, the disclosure is not limited thereto, and the laser light 16 may include YAG (FHG) having a wavelength of 266 nm or YAG (THG) having a wavelength of 355 nm. For example, laser having a wavelength of 355 nm may be used for a glass substrate instead of a quartz glass substrate, and thus costs may be reduced. However, the disclosure is not limited thereto, and laser light having any other wavelength may be used.

The beam diameter of the laser light 16 according to an embodiment of the disclosure may be greater than or equal to the chip size of one micro-LED 15. However, the beam diameter of the laser light 16 needs to be a size that does not affect the micro-LEDs 15 arranged adjacent to each other on the source substrate 114. Accordingly, the micro-LEDs 15 arranged on the source substrate 114 may be individually transferred to the driving substrate 25.

One beam of the laser beam 16 may be emitted, but it is also possible to simultaneously emit a plurality of beams at a desired pitch by using a mask or the like or by preparing a plurality of laser light sources. Accordingly, a plurality of micro-LEDs 15 may be simultaneously transferred.

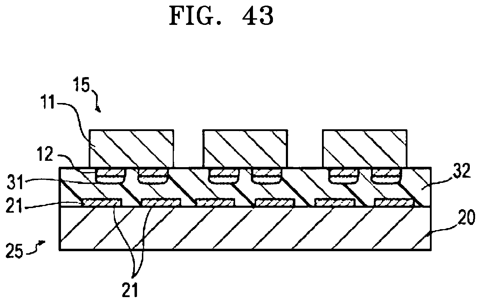

In addition, when laser ablation according to an embodiment of the disclosure is performed, the interval (gap) between the micro-LED 15 and the driving substrate 25 may be 1 $\mu$m to 200 $\mu$m. When the interval is 1 $\mu$m to 200 $\mu$m, the micro-LED 15 separated by the laser ablation may be arranged at a target position (or a position close to the target) on the driving substrate 25. FIG. 43 illustrates the driving substrate 25 to which the micro-LED 15 is transferred, according to an embodiment of the disclosure.

(Pressureless heating process)

Next, the transferred micro-LED 15 according to an embodiment of the disclosure may be connected to the driving substrate 25. By heating, without pressure, the driving substrate 25 to which the micro-LED 15 is transferred, the micro-LED 15 and the driving substrate 25 may be connected to each other. The above-described process may be referred to as a reflow process.

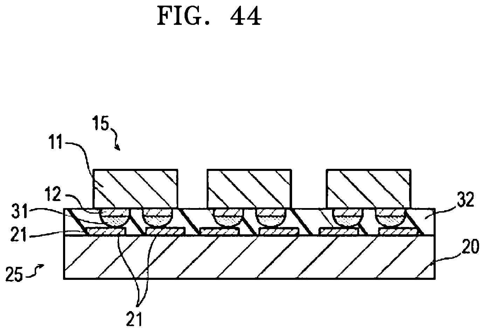

According to an embodiment of the disclosure, the reflow may be performed in two stages. For example, in a pre-heating process, the driving substrate 25 to which the micro-LED 15 is transferred may be heated without pressure. Referring to FIG. 44, the volume of the flux 32 according to an embodiment of the disclosure may be reduced as a part of the flux 32 is evaporated by the pre-heating process. The thickness of the flux 32 may be reduced by the pre-heating process, and accordingly, the solder layer 31 on the device-side electrode 12 and the driving substrate-side electrode 21 may be almost in contact with each other. The pre-heating process may be carried out, for example, at a temperature lower than the temperature at which the solder layer 31 starts to melt. The pre-heating process may be carried out, for example, at 40 °C to 120 °C. By the pre-heating process, the driving substrate-side electrode 21 and the device-side electrode 12 may be arranged more adjacent to each other. However, the disclosure is not limited thereto, and the entire heating process may be omitted.

The pressureless heating process according to an embodiment of the disclosure may be performed to apply heat, without applying external pressure, to the driving substrate 25 to which the micro-LED 15 is transferred. The pressureless heating process may be carried out at a temperature at which the solder layer 31 melts. For example, the pressureless heating process may be carried out at 200 °C to 300 °C. At this time, the micro-LED 15 may be aligned to a certain position on the driving substrate 25 by using a self-alignment effect occurring due to the surface tension of the solder layer 31 liquefied by heating as described above, and then connected to the driving substrate 25. Next, the device-side electrode 12 and the driving substrate-side electrode 21 may be connected to each other and fixed to the driving substrate 25 through the metal layer 35 that is solidified after the solder layer 31 is cooled (see FIGS. 1 and 2).

[Actions]

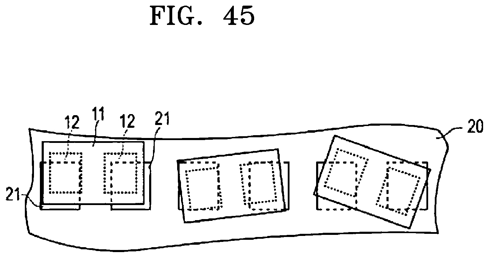

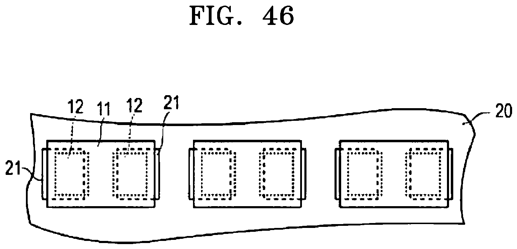

FIG. 45 is a plan view illustrating a state immediately after the micro-LED 15 is transferred to the driving substrate 25, according to an embodiment of the disclosure. FIG. 46 is a plan view illustrating a state in which the micro-LED 15 is connected to the driving substrate 25 according to an embodiment of the disclosure.

Referring to FIG. 45, immediately after the micro-LED 15 according to an embodiment of the disclosure is transferred to the driving substrate 25, the position of the micro-LED 15 may be out of the correct position, i.e., misalignment has occurred with respect to the driving substrate-side electrode 21.

Next, referring to FIG. 46, the micro-LED 15 may be aligned to a certain position on the driving substrate 25 by a pressureless heating process according to an embodiment of the disclosure, and then connected to the driving substrate 25.

In the related art, the micro-LED 15 is heated while being pressed toward the driving substrate 25 immediately after being transferred as illustrated in FIG. 45 and then connected to the driving substrate 25, and thus, the alignment position of the micro-LED 15 may be incorrect. When the alignment position of the micro-LED 15 is incorrect, image quality defects and the like may occur and thus an additional correction process or the like is required. It is necessary to, in the additional correction process, detect misalignment of the micro-LEDs 15 one by one, separate each detected misaligned micro-LEDs 15 from the solder, and connect another chip to a certain position. Such an additional correction process takes a long time in the display apparatus 10 having a large number of extremely small micro-LEDs 15 and may increase the difficulty of processing.

For example, the total number of micro-LEDs 15 in a 4K display apparatus is about 24 million. When the rate of occurrence of defects due to misalignment on the driving substrate 25 is 100 ppm, the number of defects is 2,400. A process for additionally correcting such a large number of micro-LEDs 15 may take a long time when considering that the size of the micro-LED 15 is 100 $\mu$m or less.

According to an embodiment of the disclosure, the micro-LED 15 may be aligned to a certain position by a self-alignment effect, and the number of defective micro-LEDs 15 due to misalignment may be reduced. In addition, the additional processing time required for additional correction may be reduced.

[Embodiments]

(Embodiment 1)

In Embodiment 1, after the micro-LEDs 15 were intentionally arranged at various positions on the driving substrate 25 (corresponding to the transfer process) and pressureless heating was performed, and then the positions of the micro-LEDs 15 were measured.

Manufacturing processes performed in Embodiment 1 are as follows:

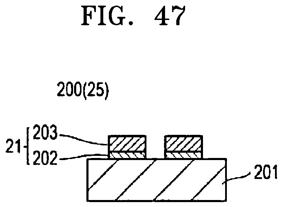

(1) Fabrication of the driving substrate 25: FIG. 47 is a cross-sectional view illustrating a test substrate 200. In the test substrate 200, an indium-zinc-oxide (IZO) film 202 was deposited on a glass substrate 201, a Cu film 203 was deposited on the IZO film 202, and the films were formed in the same shape of that of the driving substrate-side electrode 21. The thickness of the glass substrate 201 was 0.5 mm, the thickness of the IZO film 202 was 0.05 $\mu$m, and the thickness of the Cu film 203 was 1 $\mu$m. The size of the driving substrate-side electrode 21 is described below.

The test substrate 200 may correspond to the driving substrate 25 in a product. Accordingly, in the following description of embodiments of the disclosure, a component corresponding to the test substrate 200 is referred to as the driving substrate 25.

In Embodiment 1, the flux 32 (MCF Series (manufactured by Senju Metal Co., Ltd.)) was spin-coated on the driving substrate 25.

The spin coating was performed in the order of the following three stages:

First stage: 300rpm_3sec,
Second stage: 1700rpm_30sec,
Third stage: Slope_5sec.

(2) Transfer: The micro-LED 15 was transferred onto the driving substrate 25 of (1) such that the shift amount d was experimental values below. The transfer process was performed by laser ablation. In addition, the device-side electrode 12 may have a two-layer structure including the electrode metal layer 12a formed of Cu and the barrier metal layer 12b formed of Ni. Further, on the device-side electrode 12, the solder layer 31 formed of SAC305 was formed such that h0 = about 5 $\mu$m. The size of the device-side electrode 12 is described below.

Experimental values for shift amount d:

X = +3 $\mu$m, 6 $\mu$m, 9 $\mu$m,
Y = +3 $\mu$m, 6 $\mu$m, 9 $\mu$m,
XY = +3 $\mu$m, 6 $\mu$m, 9 $\mu$m (in addition, XY was set to the direction inclined upward 45 degrees from the X direction through SPc (see FIG. 7))

(3) Pressureless heating: The driving substrate 25 onto which the micro-LED 15 was transferred was placed on a hot plate at 260 °C and heated for 60 seconds under a nitrogen gas stream.

(4) Cleaning: After cooling the driving substrate 25 to room temperature, the residual flux was ultrasonically cleaned at 45 °C for 10 minutes with a cleaning solution (CLEANTHROUGH 618 (manufactured by Kao Corporation)), then additionally rinsed with ultrapure water, and blow-dried with nitrogen gas.

(5) Observation results: The positions of the micro-LEDs 15 were observed by using a microscope. The observation results are shown in Table 1. The measurement of the shift amount in the observation was performed as follows.

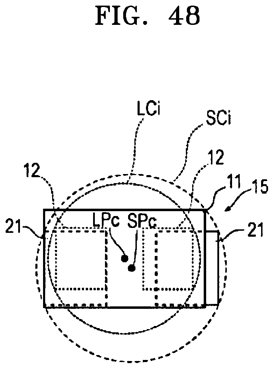

FIG. 48 is a plan view for describing measurement of a shift amount.

Referring to FIG. 48, in the measurement of the shift amount, it is assumed that the center of an outer circumferential circle SCi in contact with the outer periphery of the adjacent driving substrate-side electrodes 21 is the center SPc between the adjacent driving substrate-side electrodes 21, and it is assumed that the center of an outer circumferential circle LCi in contact with the outer periphery of the adjacent device-side electrodes 12 is the center LPc between the adjacent device-side electrodes 12. Next, the shift amount d may be determined by measuring the distance between the center position of the outer circumferential circle SCi and the center position of the outer circumferential circle LCi.

The dimensions of each device-side electrode 12 (see FIG. 3) were fixed to a = 15 $\mu$m, b = 26 $\mu$m, c = 20 $\mu$m, and Lsx = Lsy = 3 $\mu$m.

The dimensions of each driving substrate-side electrode 21 (see FIG. 4) were as shown in Table 1.

[Table 1]

| No. | | 1 | 2 | 3 | 4 |
|---|---|---|---|---|---|
| Driving substrate-side electrode | x ($\mu$m) | 21 | 21 | 13 | 13 |
| | y ($\mu$m) | 32 | 32 | 24 | 32 |
| | z ($\mu$m) | 14 | 25 | 22 | 22 |

(continued)

| No. | | 1 | 2 | 3 | 4 |
|---|---|---|---|---|---|
| Experimental value for shift amount d | 3 μm | ○ | ○ | ○ | ○ |
| | 6 μm | ○ | ○ | ○ | ○ |
| | 9 μm | ○ | ○ | X | X |
| Maximum value of shift amount d allowed by calculation (μm) | | 10.5 | 16 | 6.5 | 6.5 |

Referring to Table 1, the experimental values for the shift amount d may include 3 μm, 6 μm, and 9 μm for any one of the X direction, the Y direction, and the XY direction after the transfer process (before the pressureless heating). In addition, the maximum value (μm) of the shift amount (d) allowed by calculation may be expressed as the smaller of the values of d calculated by using Equation (1) d<x-(a+c-z)/2 or Equation (2) y/2>d.

In addition, in Table 1, '○' indicates that the product was undamaged (not defective), and when the distance between the centers of the final connection position is less than (LPc-SPc)=0±1 μm, the product was determined as being undamaged. '×' indicates that the product was defective, and when the distance between the centers of the final connection position is (LPc-SPc)≥1 μm or (LPc-SPc)≤-1 μm, the product was determined as being defective.

Referring to Table 1, the samples with experimental values of 3 μm, 6 μm, and 9 μm for the shift amount d among Nos. 1 and 2 were all determined as undamaged products. On the other hand, samples with experimental values of 3 μm and 6 μm for the shift amount d among Nos. 3 and 4 were determined as undamaged products, whereas samples with an experimental value of 9 μm for the shift amount d were determined as defective products. Among Nos. 3 and 4, the samples with an experimental value of 9 μm for the shift amount d exceeded the maximum value of the shift amount d allowed by calculation. That is, it may be found that the samples with a shift amount of 9 μm in Nos. 3 and 4 did not sufficiently exhibit a self-alignment effect.

From the above-described experimental results, it may be found that the self-alignment effect occurred when the conditions shown in Equations (1) to (6) are satisfied. That is, the above experimental results shows that, when the conditions shown in Equations (1) to (6) are satisfied, the micro-LED 15 moves in the pressureless heating process such that the center LPc of the device-side electrodes and the center SPc of the driving substrate-side electrodes are within a certain allowable range.

(Embodiment 2)

In Embodiment 2, the amount of the solder material to become the solder layer 31 was changed, and the device-side electrode 12 and the driving substrate-side electrode 21 were connected to each other by using a pressureless heating process.

The driving substrate 25 (the test substrate 200) and the micro-LED 15 used in Embodiment 2 were the same as those in Embodiment 1. The dimensions of the driving substrate-side electrode 21 were x = 21 μm, y = 32 μm, and z = 25 μm. In addition, the height h0 at the time of the deposition of the solder layer 31 is shown in Table 2.

[Table 2]

| No. | 5 | 6 | 7 | 8 |
|---|---|---|---|---|
| Height h0 of solder layer (μm) | 7 | 5 | 3 | 1.5 |
| Experimental value for shift amount d (μm) | 9 | 9 | 9 | 9 |
| Result | ○ | ○ | ○ | X |

The experimental values for the shift amount d in Table 2 may include 9 μm for any one direction of X, Y, and XY as shown in Table 1 above. In addition, '○' and '×' of the results indicate the same as those in Embodiment 1.

The solder volume V may be obtained from the height h0 and the electrode area of the solder layer 31 at the time of the deposition of the solder layer 31.

The results shown in Table 2 show that Nos. 5 to 7 are undamaged products, but No.8 is a defective product. The experimental results show that a self-alignment effect is exhibited when the volume V obtained from the height h0 and the electrode area of the solder layer 31 at the time of the deposition thereof satisfies Equations (7) and (8) above.

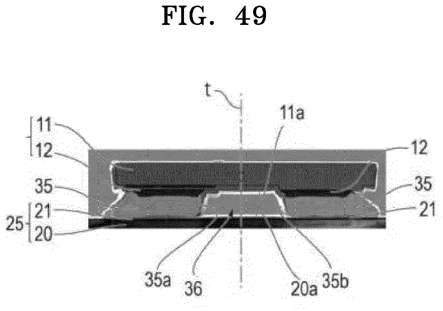

FIG. 49 is a scanning electron microscope (SEM) image showing a connection portion between the micro-LED 15 and the driving substrate 25, which are undamaged products, according to an embodiment of the disclosure.

Referring to FIG. 49, according to an embodiment of the disclosure, when the micro-LED 15 is connected to the driving substrate 25 by a pressureless heating process, the pore 36 may be between two electrodes as illustrated in FIG. 2. In addition, it may be found that the pore 36 has a polygonal shape that is line-symmetric with respect to the center line t passing between the two electrodes. In addition, it may be found that the pore 36 has a substantially trapezoidal shape.

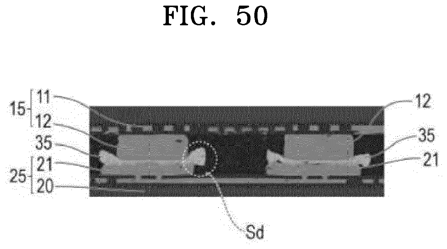

FIG. 50 is an SEM image showing a connection portion between the micro-LED 15 and the driving substrate 25, which are defective products, according to a comparative example.

In the comparative example, the micro-LED 15 was connected to the driving substrate 25 by pressure heating.

Referring to FIG. 50, it may be found that, in the comparative example, the micro-LED 15 was connected to the driving substrate 25 by pressure heating, and thus the metal layer 35 (a solder material) was pushed out from the electrode (indicated by the dashed circle (Sd)). In addition, it may be found that, in the comparative example, as compared with FIG. 49, the pore 36 between the two electrodes is not trapezoidal and does not have a shape that is line-symmetric with respect to the center line.

[Effect]

In the related art, the connection between the micro-LED 15 and the driving substrate 25 may be performed by a pressure heating process. In the pressure heating process, misalignment between the micro-LED 15 and the driving substrate 25 occurring during a transfer process remains as it is, side effects such as image defects may occur. In addition, it may take a long time to replace the defective micro-LED 15, resulting in an obstacle to mass production.

According to an embodiment of the disclosure, the micro-LED 15 may be connected to the driving substrate 25 by using a pressureless heating process. At this time, surface tension may act by the solder layer 31 being heated without pressure and thus liquefied. A self-alignment effect may occur due to the surface tension of the solder layer 31, and accordingly, the micro-LED 15 may be aligned to a certain position. Therefore, according to an embodiment of the disclosure, position misalignment or non-uniformity of the micro-LED 15 may be reduced.

In addition, according to an embodiment of the disclosure, the distance z between the driving substrate-side electrodes 21 may be arranged to exceed the distance c between the device-side electrodes 12. Accordingly, misalignment in the direction of rotation of the micro-LED 15 may also be suppressed.

In addition, According to an embodiment of the disclosure, the micro-LED 15 and the driving substrate 25 are connected to each other without pressure, and thus defects such as fractures or cracks of the micro-LED 15 that may occur when pressure is applied thereto may also be prevented.

The disclosure is not limited to the above-described embodiments. For example, the solder layer 31 may be deposited on the driving substrate-side electrode 21 instead of the device-side electrode 12 to connect the micro-LED 15 to the driving substrate 25. In addition, the solder layer 31 may be deposited on both the device-side electrode 12 and the driving substrate-side electrode 21.

Further, either or both of the device-side electrode 12 and the driving substrate-side electrode 21 are not limited to a rectangular shape. For example, either or both of the device-side electrode 12 and the driving substrate-side electrode 21 may have, for example, the shape of a triangle, a pentagon, a polygon having a larger number of sides, or a circle (including an ellipse), or may have an arbitrary shape.

In addition, various modifications are possible based on the configuration described in the claims and their equivalents, and the above-described modifications may also be within the scope of the disclosure.

**Claims**

1. A display apparatus comprising:

   a micro-light-emitting device comprising at least two device-side electrodes;
   a driving substrate comprising at least two driving substrate-side electrodes; and
   at least two metal layers, each metal layer being interposed between a corresponding device-side electrode, among the at least two device-side electrodes, and a corresponding driving substrate-side electrode, among the at least two driving substrate-side electrodes, and connecting the corresponding device-side electrode, among the at least two device-side electrodes, to the corresponding driving substrate-side electrode, among the at least two driving substrate-side electrodes,
   wherein a distance between adjacent driving substrate-side electrodes, among the at least two driving substrate-side electrodes, is greater than a distance between adjacent device-side electrodes, among the at least two device-side electrodes, and
   wherein each metal layer of the at least two metal layers is a metal formed by undergoing heating without pressure applied thereto and then curing during a process of connecting the at least two device-side electrodes to the at least two driving substrate-side electrodes.

2. A display apparatus comprising:

a micro-light-emitting device;
at least two device-side electrodes provided on the micro-light-emitting device;
a driving substrate;
at least two driving substrate-side electrodes provided on the driving substrate;
at least two metal layers, each metal layer being interposed between a corresponding device-side electrode, among the at least two device-side electrodes, and a corresponding driving substrate-side electrode, among the at least two driving substrate-side electrodes, and connecting the corresponding device-side electrode, among the at least two device-side electrodes, to the corresponding driving substrate-side electrode, among the at least two driving substrate-side electrodes, respectively; and
a pore in an area between adjacent device-side electrodes, among the at least two device-side electrodes, and between adjacent driving substrate-side electrodes, among the at least two driving substrate-side electrodes, that are connected to the adjacent device-side electrodes, respectively,
wherein the pore has a polygonal cross-sectional shape that is line-symmetric with respect to a center line passing through a center between the adjacent device-side electrodes and a center between the adjacent driving substrate-side electrodes.

3. The display apparatus of claim 2, wherein the pore has a trapezoidal cross-sectional shape comprising an upper base between the adjacent device-side electrodes of the micro-light-emitting device, a lower base between the adjacent driving substrate-side electrodes of the driving substrate, and a lateral portion between the upper base and the lower base.

4. The display apparatus of claim 1 or 2, wherein a dimension of a device-side electrode, among the adjacent device-side electrodes, and a dimension of a driving substrate-side electrode, among the adjacent driving substrate-side electrodes, are determined according to Equations (1), (2), (3), (4), and (5):

$$(1)\ d<x-(a+c-z)/2;$$

$$(2)\ y/2>d;$$

$$(3)\ z<a+c;$$

$$(4)\ x<2a+c-z;$$

and

$$(5)\ y<a+c,$$

wherein a direction in which the adjacent device-side electrodes and the adjacent driving substrate-side electrodes are arranged is a first direction (an X direction), a direction orthogonal to the first direction X is a second direction (a Y direction), and
wherein a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, z denotes a distance between the adjacent driving substrate-side electrodes, and d denotes a difference between a center between the adjacent device-side electrodes and a center between the adjacent driving substrate-side electrodes.

5. The display apparatus of claim 1 or 2, wherein a dimension of a device-side electrode, among the at least two device-side electrodes, and a dimension of a driving substrate-side electrode, among the at least two driving substrate-side electrodes, are determined according to Equations (1), (2), (3), and (4):

$$(1)\ \sqrt{(x^2+y^2)}<a+c;$$

$$(2)\ z<a+c;$$

$$(3)\ x<2a+c-z;$$

; and

$$(4)\ y<a+c,$$

wherein a direction in which the adjacent device-side electrodes and the adjacent driving substrate-side electrodes are arranged is a first direction (an X direction), a direction orthogonal to the first direction X is a second direction (a Y direction), and

wherein a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, and z denotes a distance between the adjacent driving substrate-side electrodes.

6. The display apparatus of claim 4 or 5, wherein a volume V of a metal layer of the at least two metal layers is determined according to Equation (5):

$$(5)\ 0.059\times a\times b^2<V<0.393\times a\times b^2,$$

wherein b denotes a length of the device-side electrode in the Y direction.

7. The display apparatus of claim 1 or 2, wherein each of the at least two metal layers comprises a Sn-Ag-Cu (SAC) alloy solder material.

8. The display apparatus of claim 1 or 2, wherein each of the at least two device-side electrodes comprises an electrode metal layer and a barrier metal layer, which are sequentially arranged from a side adjacent to the micro-light-emitting device.

9. The display apparatus of claim 8, wherein the barrier metal layer comprises Ni.

10. The display apparatus of claim 1 or 2, wherein a surface of each of the at least two device-side electrodes and a surface of each of the at least two driving substrate-side electrodes comprise an element from Group 10 or Group 11 of the periodic table of elements.

11. A method of manufacturing a display apparatus in which a micro-light-emitting device and a driving substrate are connected to each other, the method comprising:

depositing a metal layer on at least one of at least two device-side electrodes of the micro-light-emitting device and at least two driving substrate-side electrodes of the driving substrate;
transferring the micro-light-emitting device onto the driving substrate such that the at least two driving substrate-side electrodes and the at least two device-side electrodes correspond to each other, respectively; and
heating, without applying pressure, the driving substrate to which the micro-light-emitting device is transferred.

12. The method of claim 11, wherein a distance between adjacent driving substrate-side electrodes, among the at least two driving substrate-side electrodes is greater than a distance between adjacent device-side electrodes, among the at least two device-side electrodes.

**EP 4 394 866 A1**

13. The method of claim 11, wherein a dimension of a device-side electrode among the adjacent device-side electrodes, and a dimension of a driving substrate-side electrode, among the adjacent driving substrate-side electrodes, are determined according to Equations (1), (2), (3), (4), and (5):

$$(1)\ d < x - (a+c-z)/2;$$

$$(2)\ y/2 > d;$$

$$(3)\ z < a+c;$$

$$(4)\ x < 2a+c-z;$$

and

$$(5)\ y < a+c,$$

wherein a direction in which the device-side electrodes and the driving substrate-side electrodes are arranged is a first direction (an X direction), a direction orthogonal to the first direction X is a second direction (a Y direction), and

wherein a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, z denotes a distance between the adjacent driving substrate-side electrodes, and d denotes a difference between a center between the adjacent device-side electrodes and a center between the adjacent driving substrate-side electrodes.

14. The method of claim 11, wherein a dimension of a device-side electrode among the adjacent device-side electrodes, and a dimension of a driving substrate-side electrode, among the adjacent driving substrate-side electrodes, are determined according to Equations (1), (2), (3), and (4):

$$(1)\ \sqrt{(x^2+y^2)} < a+c;$$

$$(2)\ z < a+c;$$

$$(3)\ x < 2a+c-z;$$

and

$$(4)\ y < a+c,$$

wherein a direction in which the device-side electrodes and the driving substrate-side electrodes are arranged is a first direction (an X direction), a direction orthogonal to the first direction X is a second direction (a Y direction), and

wherein a denotes a length of the device-side electrode in the X direction, c denotes a distance between the adjacent device-side electrodes, x denotes a length of the driving substrate-side electrode in the X direction, y denotes a length of the driving substrate-side electrode in the Y direction, and z denotes a distance between the adjacent driving substrate-side electrodes.

15. The method of claim 13 or 14, wherein

a volume V of the metal layer is determined according to Equation (6):

$$(6) \quad 0.059 \times a \times b^2 < V < 0.393 \times a \times b^2,$$

wherein b denotes a length of the device-side electrode in the Y direction.

FIG. 1

## FIG. 2

FIG. 3

FIG. 4

# FIG. 5

# FIG. 6

$$d= \mid LPc\text{-}SPc \mid >0$$

FIG. 7

# FIG. 8

FIG. 9

## FIG. 10

FIG. 11

# FIG. 12

## FIG. 13

# FIG. 14

FIG. 15

# FIG. 16

$$d < x - (a + c - z)/2$$

# FIG. 17

FIG. 18

# FIG. 19

$d > x - (a+c-z)/2$

# FIG. 20

y/2<d

12    11    12    15

Lc    LPc    Lc

y/2

y

Sc    SPc    Sc

d

Y

→X

21    21

FIG. 21

$$\sqrt{(x^2+y^2)} < a+c, \ y > x$$

# FIG. 22

$$\sqrt{(x^2+y^2)} < a+c \ , \ y > x$$

# FIG. 23

$$\sqrt{(x^2+y^2)}<a+c\ ,\ y>x$$

# FIG. 24

$$\sqrt{(x^2+y^2)} < a+c \,, y > x$$

# FIG. 25

# FIG. 26

# FIG. 27

# FIG. 28

z<a+c

FIG. 29

$x<2a+c-z$

2a+c

a    c    a

15

11    11

12    12

Lc    LPc    Lc

21    21

Sc    SPc    Sc

z+x

x/2    x/2

Y

X    z    x

X

FIG. 30

# FIG. 31

# FIG. 32

y>a+c

# FIG. 33

y>a+c

FIG. 34

FIG. 35

FIG. 36

FIG. 37

FIG. 38

# FIG. 39

FIG. 40

# FIG. 41

FIG. 42

# FIG. 43

FIG. 44

FIG. 45

FIG. 46

FIG. 47

200(25)

203
21
202

201

FIG. 48

FIG. 49

FIG. 50

| INTERNATIONAL SEARCH REPORT | International application No. |
|---|---|
| | **PCT/KR2022/020156** |

| **A.** | **CLASSIFICATION OF SUBJECT MATTER** |
|---|---|

**H01L 25/075**(2006.01)i; **H01L 27/12**(2006.01)i; **H01L 33/62**(2010.01)i; **H01L 33/36**(2010.01)i; **H01L 33/40**(2010.01)i; **H01L 23/00**(2006.01)i

According to International Patent Classification (IPC) or to both national classification and IPC

| **B.** | **FIELDS SEARCHED** |
|---|---|

Minimum documentation searched (classification system followed by classification symbols)

H01L 25/075(2006.01); H01L 21/60(2006.01); H01L 21/683(2006.01); H01L 23/00(2006.01); H01L 25/16(2006.01); H01L 33/00(2010.01); H01L 33/62(2010.01); H05K 13/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 마이크로 발광 소자(micro light emitting diode), 무가압(non-pressurized), 가열 (heating), 전극(electrode), 거리(distance)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | KR 10-2021-0120406 A (LC SQUARE CO., LTD.) 07 October 2021 (2021-10-07) See paragraphs [0018] and [0039]-[0080] and figures 9a-12b. | 2,3,7,10 |
| Y | | 8,9,11 |
| A | | 1,4-6,12-15 |
| Y | KR 10-2021-0133777 A (SAMSUNG ELECTRONICS CO., LTD.) 08 November 2021 (2021-11-08) See paragraphs [0056], [0065] and [0067] and figure 4a. | 8,9 |
| Y | KR 10-2020-0137978 A (SEOUL NATIONAL UNIVERSITY R&DB FOUNDATION) 09 December 2020 (2020-12-09) See paragraphs [0024] and [0041], claims 1 and 2 and figures 5 and 6. | 11 |
| A | JP 2020-167251 A (TORAY ENG CO., LTD.) 08 October 2020 (2020-10-08) See claims 1-4. | 1-15 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **28 March 2023** | **03 April 2023** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2022/020156**

**C.    DOCUMENTS CONSIDERED TO BE RELEVANT**

| Category* | Citation of document, with indication, where appropriate, of the relevant passages | Relevant to claim No. |
|---|---|---|
| A | US 2021-0005588 A1 (SAMSUNG ELECTRONICS CO., LTD.) 07 January 2021 (2021-01-07) See paragraphs [0089]-[0236] and figures 4-20. | 1-15 |

Form PCT/ISA/210 (second sheet) (July 2022)

INTERNATIONAL SEARCH REPORT
Information on patent family members

International application No.

**PCT/KR2022/020156**

| Patent document cited in search report | | | Publication date (day/month/year) | Patent family member(s) | | | Publication date (day/month/year) |
|---|---|---|---|---|---|---|---|
| KR | 10-2021-0120406 | A | 07 October 2021 | KR | 10-2463048 | B1 | 07 November 2022 |
| KR | 10-2021-0133777 | A | 08 November 2021 | WO | 2021-221454 | A1 | 04 November 2021 |
| KR | 10-2020-0137978 | A | 09 December 2020 | KR | 10-2311727 | B1 | 13 October 2021 |
| JP | 2020-167251 | A | 08 October 2020 | None | | | |
| US | 2021-0005588 | A1 | 07 January 2021 | KR | 10-2021-0004324 | A | 13 January 2021 |
| | | | | US | 11404403 | B2 | 02 August 2022 |
| | | | | WO | 2021-002610 | A1 | 07 January 2021 |

Form PCT/ISA/210 (patent family annex) (July 2022)